# EUROPEAN PATENT APPLICATION

(11) **EP 4 425 559 A1**
(43) Date of publication of application: **04.09.2024**
(21) Application number: 22886511.9
(22) Date of filing: 15.09.2022
(51) Int. Cl.: H01L 27/146, H04N 25/70, H04N 25/778

(54) **IMAGING DEVICE**

(30) Priority: 27.10.2021 JP 2021175964
(71) Applicant: Sony Semiconductor Solutions Corporation, Atsugi-shi, Kanagawa 243-0014 (JP)
(72) Inventor: NAKAMOTO, Yuta, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/034626
(87) International publication number: WO 2023/074177

(57) **Abstract**

There are provided: a pixel separation section including an insulating film and extending in first and second directions between pixels and extending from a first surface of a semiconductor substrate toward a second surface; pixel transistors provided on the second surface side, arranged in the first direction to overlap the pixel separation section extending in the first direction in plan view, constituting a readout circuit that outputs a pixel signal based on electric charge outputted from each of light-receiving pixels; and an element separation section including an insulating film formed to be embedded on the second surface side, extending in the first direction along the pixel transistors arranged in the first direction, being divided at at least a portion of an intersection of the pixel separation section extending in the first and second directions in plan view, and electrically separating the pixel transistors and light-receiving sections from each other.

## Description

### Technical Field

The present disclosure relates to an imaging device that captures an image of a subject.

### Background Art

For example, PTL 1 discloses a semiconductor device in which a thermal oxide film is formed on an inner periphery of a groove section constituting an STI and the inside thereof is filled with a polysilicon film as a filler.

### Citation List

### Patent Literature

PTL 1: Japanese Unexamined Patent Application Publication No. 2006-59842

### Summary of the Invention

An imaging device is desired to have improved image quality of a captured image.

It is desirable to provide an imaging device that makes it possible to improve image quality of a captured image.

An imaging device according to an embodiment of the present disclosure includes: a semiconductor substrate having a first surface and a second surface opposed to each other and including a plurality of light-receiving sections, the plurality of light-receiving sections including a plurality of light-receiving pixels being arranged in a two-dimensional array in a first direction and a second direction intersecting the first direction, the plurality of light-receiving sections generating electric charge corresponding to a received light amount for each of the light-receiving pixels by photoelectric conversion; a pixel separation section including an insulating film and extending in the first direction and the second direction between the light-receiving pixels adjacent to each other to surround each of the plurality of light-receiving pixels, the pixel separation section extending from the first surface toward the second surface; a plurality of pixel transistors provided on a side of the second surface and arranged in the first direction to overlap with the pixel separation section extending in the first direction in a plan view, the plurality of pixel transistors constituting a readout circuit that outputs a pixel signal based on the electric charge outputted from each of the plurality of light-receiving pixels; and an element separation section including an insulating film that is formed to be embedded on the side of the second surface and extending in the first direction along the plurality of pixel transistors arranged in the first direction, the element separation section being divided at at least a portion of an intersection of the pixel separation section that extends in the first direction and the second direction in a plan view, the element separation section electrically separating the plurality of pixel transistors and the plurality of light-receiving sections from each other.

In the imaging device according to an embodiment of the present disclosure, the pixel separation section including an insulating film is provided that extends in the first direction and the second direction between the light-receiving pixels adjacent to each other to surround each of the plurality of light-receiving pixels and extends from the first surface of the semiconductor substrate to the second surface. On the second surface of the semiconductor substrate, the plurality of pixel transistors arranged in the first direction and the element separation section including an insulating film are provided to overlap with the pixel separation section extending in the first direction in a plan view. The element separation section electrically separates the plurality of pixel transistors and the plurality of light-receiving sections provided respectively in the plurality of light-receiving pixels from each other. The element separation section extends in the first direction along the plurality of pixel transistors arranged in the first direction, and is divided at at least a portion of the intersection of the pixel separation section extending in the first direction and the second direction, in a plan view. This reduces stress to be applied to the inside of the semiconductor substrate.

### Brief Description of the Drawings

[FIG. 1] FIG. 1 is a block diagram illustrating a configuration example of an imaging device according to an embodiment of the present disclosure.
[FIG. 2] FIG. 2 is an explanatory diagram illustrating a configuration example of a pixel array illustrated in FIG. 1.
[FIG. 3] FIG. 3 is a schematic view of an example of a cross-sectional configuration of light-receiving pixels illustrated in FIG. 2.
[FIG. 4] FIG. 4 is a circuit diagram illustrating a configuration example of a pixel block illustrated in FIG. 2.
[FIG. 5] FIG. 5 is a circuit diagram illustrating a configuration example of another pixel block illustrated in FIG. 2.
[FIG. 6] FIG. 6 is an explanatory diagram illustrating an example of a planar arrangement of pixel transistors in the pixel blocks illustrated in FIG. 2.
[FIG. 7A] FIG. 7A is a schematic view of an example of a cross-sectional configuration of the light-receiving pixel corresponding to a line II-II' illustrated in FIG. 6.
[FIG. 7B] FIG. 7B is a schematic view of an example of a cross-sectional configuration of the light-receiving pixel corresponding to a line III-III' illustrated in FIG. 6.
[FIG. 8A] FIG. 8A is a circuit diagram illustrating an example of a configuration of a pixel block upon addition of a transistor FDG as the pixel transistor.
[FIG. 8B] FIG. 8B is a circuit diagram illustrating another example of the configuration of the pixel block upon the addition of the transistor FDG as the pixel transistor.
[FIG. 8C] FIG. 8C is a circuit diagram illustrating an example of a configuration of another pixel block upon the addition of the transistor FDG as the pixel transistor.
[FIG. 8D] FIG. 8D is a circuit diagram illustrating another example of the configuration of the other pixel block upon the addition of the transistor FDG as the pixel transistor.
[FIG. 8E] FIG. 8E is an explanatory diagram illustrating an example of a planar arrangement of pixel transistors upon the addition of the transistor FDG as the pixel transistor.
[FIG. 9] FIG. 9 is a block diagram illustrating a configuration example of a readout section illustrated in FIG. 1.
[FIG. 10] FIG. 10 is an explanatory diagram illustrating a configuration example of an image signal illustrated in FIG. 1.
[FIG. 11] FIG. 11 is an explanatory diagram illustrating an example of the number of effective pixels in the imaging device illustrated in FIG. 1.
[FIG. 12] FIG. 12 is an explanatory diagram illustrating an operation example of a plurality of imaging modes in the imaging device illustrated in FIG. 1.
[FIG. 13] FIG. 13 is an explanatory diagram illustrating an operation example of the imaging device illustrated in FIG. 1.
[FIG. 14] FIG. 14 is a timing waveform chart illustrating an example of a readout operation in the imaging device illustrated in FIG. 1.
[FIG. 15] FIG. 15 is another explanatory diagram illustrating an operation example of the imaging device illustrated in FIG. 1.
[FIG. 16] FIG. 16 is another explanatory diagram illustrating an operation example of the imaging device illustrated in FIG. 1.
[FIG. 17] FIG. 17 is another explanatory diagram illustrating an operation example of the imaging device illustrated in FIG. 1.
[FIG. 18] FIG. 18 is another explanatory diagram illustrating an operation example of the imaging device illustrated in FIG. 1.
[FIG. 19] FIG. 19 is an explanatory diagram illustrating an example of remosaic processing in the imaging device illustrated in FIG. 1.
[FIG. 20A] FIG. 20A is an explanatory diagram illustrating an example of the remosaic processing illustrated in FIG. 19.
[FIG. 20B] FIG. 20B is another explanatory diagram illustrating the example of the remosaic processing illustrated in FIG. 19.
[FIG. 20C] FIG. 20C is another explanatory diagram illustrating the example of the remosaic processing illustrated in FIG. 19.
[FIG. 21] FIG. 21 is an explanatory diagram illustrating an example of a planar configuration of an imaging device according to a modification example of the present disclosure.
[FIG. 22] FIG. 22 is an explanatory diagram illustrating another example of the planar configuration of the imaging device according to the modification example of the present disclosure.
[FIG. 23] FIG. 23 is an explanatory diagram illustrating another example of the planar configuration of the imaging device according to the modification example of the present disclosure.
[FIG. 24] FIG. 24 is an explanatory diagram illustrating another example of the planar configuration of the imaging device according to the modification example of the present disclosure.
[FIG. 25] FIG. 25 is an explanatory diagram illustrating a usage example of the imaging device.
[FIG. 26] FIG. 26 is a block diagram depicting an example of schematic configuration of a vehicle control system.
[FIG. 27] FIG. 27 is a diagram of assistance in explaining an example of installation positions of an outside-vehicle information detecting section and an imaging section.

### Modes for Carrying Out the Invention

Hereinafter, detailed description is given of an embodiment of the present disclosure with reference to the drawings. It is to be noted that the description is given in the following order.
1. Embodiment
2. Modification Examples
3. Usage Example of Imaging Device
4. Example of Practical Application to Mobile Body

### <1. Embodiment>

### [Configuration Example]

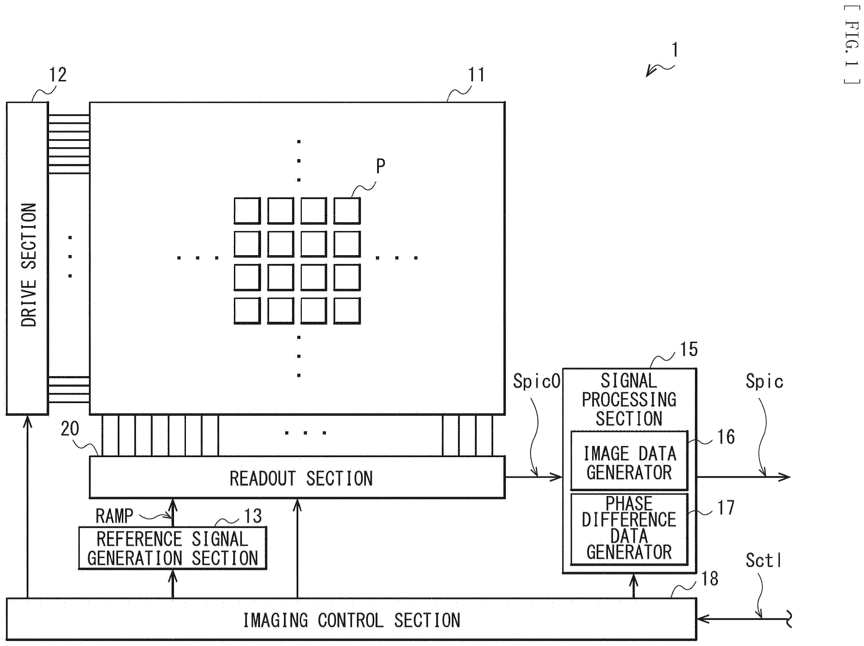

FIG. 1 illustrates a configuration example of an imaging device (an imaging device 1) according to an embodiment of the present disclosure. The imaging device 1 includes a pixel array 11, a drive section 12, a reference signal generation section 13, a readout section 20, a signal processing section 15, and an imaging control section 18.

The pixel array 11 includes a plurality of light-receiving pixels P arranged in a two-dimensional array. The light-receiving pixel P is configured to generate a signal SIG including a pixel voltage Vpix corresponding to a received light amount.

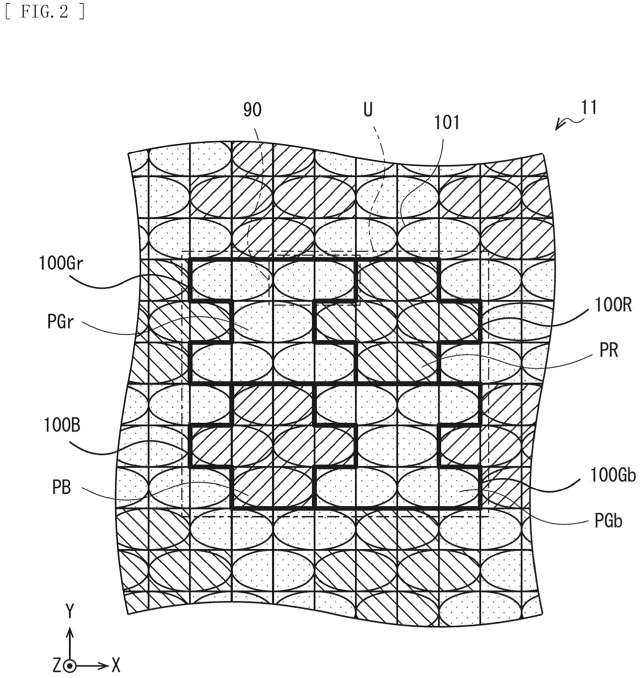

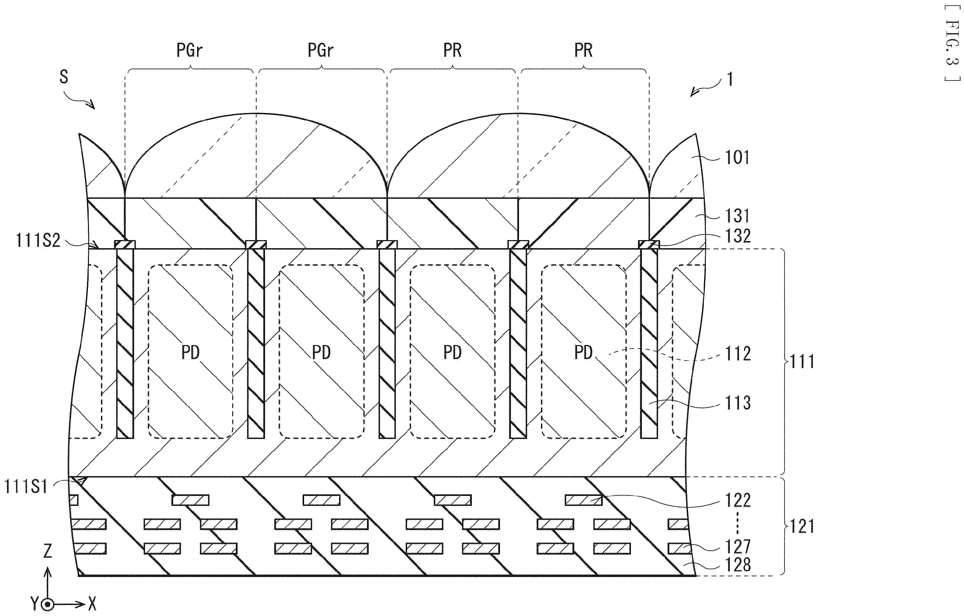

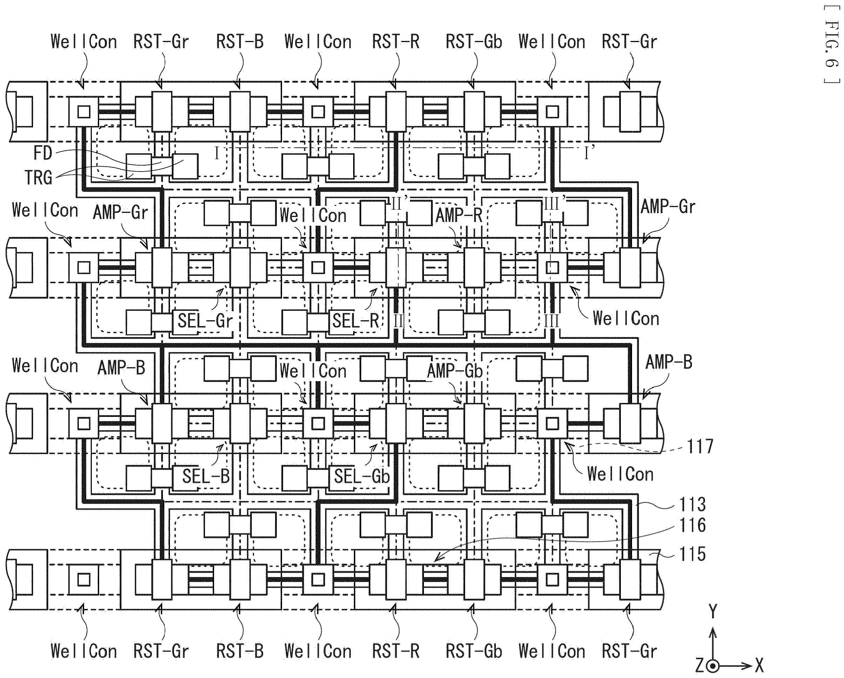

FIG. 2 illustrates an example of an arrangement of the light-receiving pixels P in the pixel array 11. FIG. 3 illustrates an example of an outline cross-sectional structure of the pixel array 11. It is to be noted that FIG. 3 illustrates a cross-section corresponding to a line I-I' illustrated in FIG. 6. The pixel array 11 includes a plurality of pixel blocks 100 and a plurality of lenses 101.

The plurality of pixel blocks 100 includes pixel blocks 100R, 100Gr, 100Gb, and 100B. In the pixel array 11, the plurality of light-receiving pixels P is arranged in minimum repeating units (units U) of the four pixel blocks 100 (the pixel blocks 100R, 100Gr, 100Gb, and 100B).

The pixel block 100R includes, for example, eight light-receiving pixels P (light-receiving pixels PR) including color filters 131 of red (R), for example. The pixel block 100Gr includes, for example, ten light-receiving pixels P (light-receiving pixels PGr) including color filters 131 of green (G), for example. The pixel block 100Gb includes, for example, ten light-receiving pixels P (light-receiving pixels PGb) including color filters 131 of green (G), for example. The pixel block 100B includes, for example, eight light-receiving pixels P (light-receiving pixels PB) including color filters 131 of blue (B), for example. In FIG. 2, differences in the colors between the color filters are expressed with hatch patterns. An arrangement pattern of the light-receiving pixels PR in the pixel block 100R and an arrangement pattern of the light-receiving pixels PB in the pixel block 100B are the same as each other. An arrangement pattern of the light-receiving pixels PGr in the pixel block 100Gr and an arrangement pattern of the light-receiving pixels PGb in the pixel block 100Gb are the same as each other.

In the unit U, the pixel blocks 100R, 100Gr, 100Gb, and 100B are arranged in two rows × two columns, for example. Specifically, the pixel block 100R and the pixel block 100B having the same arrangement pattern and the pixel block 100Gr and the pixel block 100Gb having the same arrangement pattern are arranged respectively on diagonal lines intersecting each other. As an example, the pixel block 100Gr is disposed on the upper left, the pixel block 100R is disposed on the upper right, the pixel block 100B is disposed on the lower left, and the pixel block 100Gb is disposed on the lower right. In such a manner, the pixel blocks 100R, 100Gr, 100Gb, and 100B are arranged in a so-called Bayer arrangement in units of pixel blocks 100.

Here, the light-receiving pixel P corresponds to a specific example of a "light-receiving pixel" in the present disclosure. A pixel pair 90A corresponds to a specific example of a "pixel pair" in the present disclosure. The pixel block 100 corresponds to a specific example of a "pixel block" in the present disclosure. For example, the pixel block 100Gr and the pixel block 100Gb each correspond to a specific example of a "first pixel block" in the present disclosure. For example, the pixel block 100R and the pixel block 100B each correspond to a specific example of a "second pixel block" in the present disclosure.

As illustrated in FIG. 3, the pixel array 11 includes, for example, a semiconductor substrate 111, a light-receiving section 112, a pixel separation section 113, a multilayer wiring layer 121, the color filter 131, and a light-blocking section 132.

The semiconductor substrate 111 is a support substrate to form the imaging device 1. The semiconductor substrate 111 is, for example, a P-type semiconductor substrate having a pair of surfaces (a front surface 111S1 and a back surface 111S2) opposed to each other. The light-receiving section 112 is a semiconductor region formed to be embedded at a position corresponding to each of the plurality of light-receiving pixels P in the substrate of the semiconductor substrate 111, in which a photodiode (PD) is formed by doping with N-type impurities, for example. The pixel separation section 113 extends in an X-axis direction and a Y-axis direction between the light-receiving pixels P adjacent to each other to surround each of the plurality of light-receiving pixels P, extends from the back surface 111S2 toward the front surface 111S1, and has the end in the semiconductor substrate 111. In other words, the pixel separation section 113 is provided at a boundary between the plurality of light-receiving pixels P adjacent to each other in an X-Y plane in the substrate of the semiconductor substrate 111, and is, for example, a DTI (Deep Trench Isolation) configured using an insulating material such as an oxide film. The pixel separation section 113 is provided, for example, in a grid pattern across the entire surface of the pixel array 11.

The multilayer wiring layer 121 is provided on the front surface 111S1 of the semiconductor substrate 111, which is a surface opposite to a light incident side S of the pixel array 11. The multilayer wiring layer 121 includes, for example, a plurality of wiring layers 122 to 127 and an interlayer insulating layer 128. The plurality of wiring layers 122 to 127 are provided in order from a side of the back surface 1 1 1S2 of the semiconductor substrate 111. The plurality of wiring layers 122 to 127 includes, for example, a plurality of transistors provided on the front surface 111S 1 of the semiconductor substrate 111 and a plurality of wiring lines such as a control line TRGL described later, for example, to couple the drive section 12 and the readout section 20 to each other.

The color filter 131 is provided on the back surface 111S2 of the semiconductor substrate 111, which is the light incident side S of the pixel array 11. The light-blocking section 132 is provided, on the back surface 111S2 of the semiconductor substrate 111, to surround two light-receiving pixels P (hereinafter, also referred to as the pixel pair 90A) adjacent to each other in an X-axis direction.

The plurality of lenses 101 is each a so-called on-chip lens, and is provided on the color filters 131 on the light incident side S of the pixel array 11. The lens 101 is provided over the two light-receiving pixels P (pixel pair 90A) adjacent to each other in the X-axis direction. Four lenses 101 are provided over the eight light-receiving pixels P in the pixel block 100R. Five lenses 101 are provided over the ten light-receiving pixels P in the pixel block 100Gr. Five lenses 101 are provided over the ten light-receiving pixels P in the pixel block 100Gb. Four lenses 101 are provided over the eight light-receiving pixels Pin the pixel block 100B. The lenses 101 are provided side by side in the X-axis direction and the Y-axis direction. The lenses 101 side by side in the Y-axis direction are arranged to be shifted from each other in the X-axis direction by one light-receiving pixel P. In other words, the pixel pairs 90A side by side in the Y-axis direction are arranged to be shifted from each other in the X-axis direction by one light-receiving pixel P.

This configuration allows images to be shifted from each other in the two light-receiving pixels P in the pixel pair 90A corresponding to one lens 101. The imaging device 1 generates phase difference data DF on the basis of a so-called image-plane phase difference detected by the plurality of pixel pairs 90A. For example, a camera mounted with the imaging device 1 determines a defocus amount on the basis of the phase difference data DF, and moves the position of an imaging lens on the basis of this defocus amount. The camera is able to achieve autofocusing in such a manner.

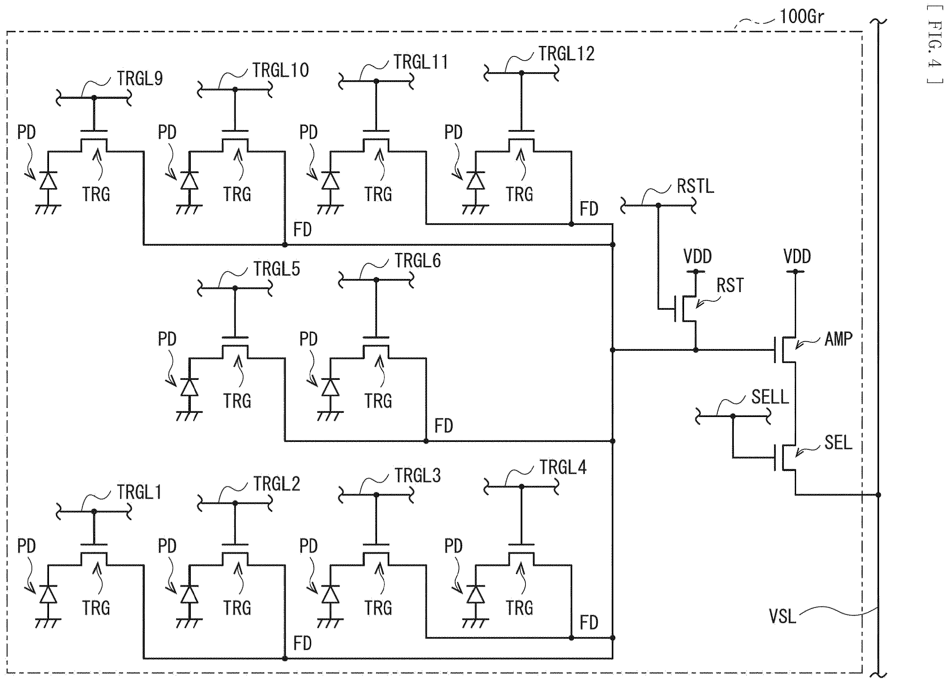

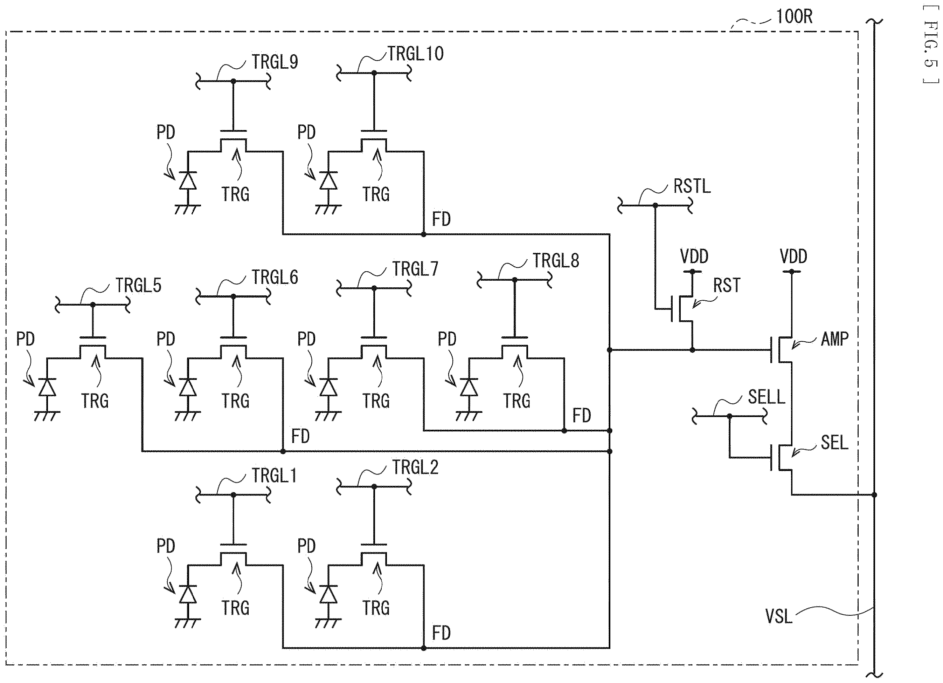

FIG. 4 illustrates a configuration example of the pixel block 100Gr. FIG. 5 illustrates a configuration example of the pixel block 100R.

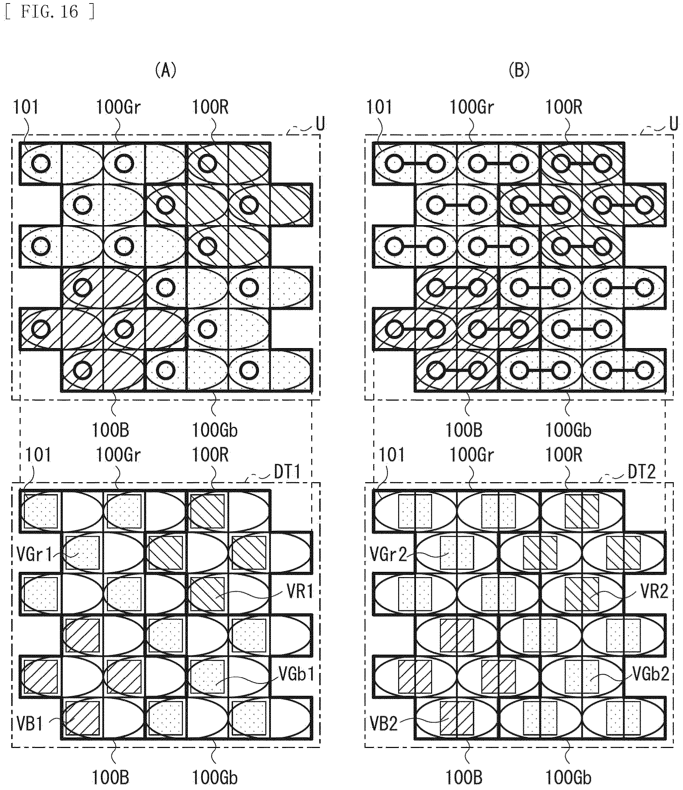

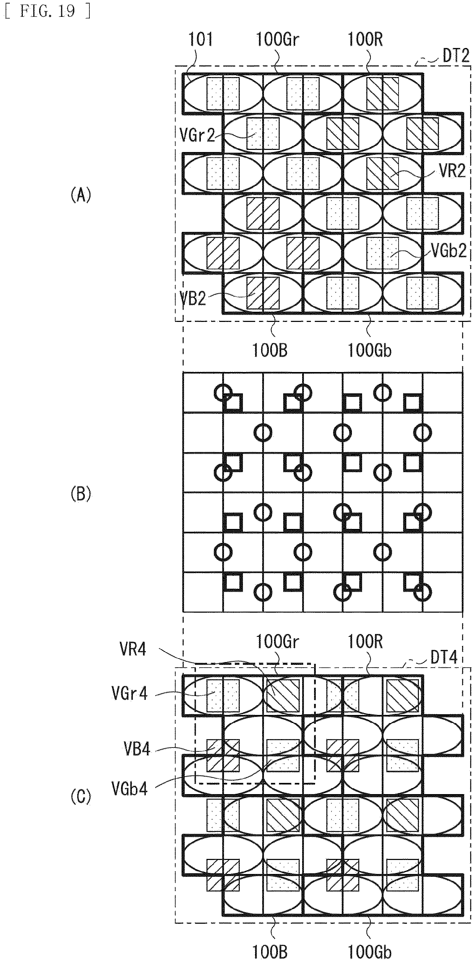

The pixel array 11 includes a plurality of control lines TRGL, a plurality of control lines RSTL, a plurality of control lines SELL, and a plurality of signal lines VSL. For example, the control lines TRGL extend in the X-axis direction (see, e.g., FIGs. 16 to 18), and have respective one ends coupled to the drive section 12. The drive section 12 supplies control signals STRGto the control lines TRGL. For example, the control lines RSTL extend in the X-axis direction (see, e.g., FIG. 16), and have respective one ends coupled to the drive section 12. The drive section 12 supplies control signals SRST to the control lines RSTL. For example, the control lines SELL extend in the X-axis direction (see, e.g., FIG. 16), and have respective one ends coupled to the drive section 12. The drive section 12 supplies control signals SSEL to the control lines SELL. For example, the signal lines VSL extend in the Y-axis direction (see, e.g., FIG. 19), and have respective one ends coupled to the readout section 20. The signal lines VSL transfer the signals SIG generated by the light-receiving pixels P to the readout section 20.

The pixel block 100Gr (FIG. 4) includes, for example, ten photodiodes, ten transistors TRG, five floating diffusion layers (FD), and one transistor RST, one transistor AMP and one transistor SEL, each as a pixel transistor. The ten photodiodes and the ten transistors TRG each respectively correspond to the ten light-receiving pixels PGr included in the pixel block 100Gr. The five floating diffusion layers are arranged one by one for the respective pixel pairs 90A. In other words, each of the five floating diffusion layers is shared by the two light-receiving pixels P constituting the pixel pair 90A and being adjacent to each other in the X-axis direction. The transistors TRG, RST, AMP, and SEL in this example are each an N-type MOS (Metal Oxide Semiconductor) transistor. The five floating diffusion layers and the transistors TRG, RST, AMP, and SEL are each provided on the front surface 111S1 of the semiconductor substrate 111.

The photodiode is a photoelectric conversion element that generates electric charge in an amount corresponding to a received light amount and accumulates therein the generated electric charge. The photodiode has an anode grounded and a cathode coupled to a source of the transistor TRG.

The transistor TRG transfers the electric charge generated by the photodiode to the floating diffusion layer. The transistor TRG has a gate coupled to the control line TRGL, the source coupled to the cathode of the photodiode, and a drain coupled to the floating diffusion layer. The gates of the ten transistors TRG are coupled to respective different control lines TRGL among the ten control lines TRGL (in this example, control lines TRGL1 to TRGL6 and TRGL9 to TRGL12).

The floating diffusion layer is configured to accumulate the electric charge transferred from the photodiode via the transistor TRG. The floating diffusion layer is configured using, for example, a diffusion layer formed on a front surface of a semiconductor substrate.

The transistor RST has a gate coupled to the control line RSTL, a drain to be supplied with a power supply voltage VDD, and a source coupled to the floating diffusion layer.

The transistor AMP has a gate coupled to the floating diffusion layer, a drain to be supplied with the power supply voltage VDD, and a source coupled to a drain of the transistor SEL.

The transistor SEL has a gate coupled to the control line SELL, the drain coupled to the source of the transistor AMP, and a source coupled to the signal line VSL.

With this configuration, in the light-receiving pixel P, for example, the electric charge accumulated in the photodiode is discharged by bringing the transistors TRG and RST each into an ON state on the basis of the control signals STRG and SRST. Then, an exposure period T is started by bringing the transistors TRG and RST each into an OFF state, and electric charge in an amount corresponding to a received light amount is thus accumulated in the photodiode. Then, after the exposure period T ends, the light-receiving pixel P outputs the signal SIG including a reset voltage Vreset and the pixel voltage Vpix to the signal line VSL. Specifically, first, the light-receiving pixel P is electrically coupled to the signal line VSL by bringing the transistor SEL into an ON state on the basis of the control signal SSEL. The transistor AMP is thereby coupled to a constant current source 21 (described later) of the readout section 20, thus operating as a so-called source follower. Then, during a P-phase (Pre-Charge phase) period TP after the voltage of the floating diffusion layer is reset by bringing the transistor RST into an ON state, as described later, the light-receiving pixel P outputs a voltage corresponding to the voltage of the floating diffusion layer at that time as the reset voltage Vreset. Further, during a D-phase (Data phase) period TD after electric charge is transferred from the photodiode to the floating diffusion layer by bringing the transistor TRG into an ON state, the light-receiving pixel P outputs a voltage corresponding to the voltage of the floating diffusion layer at that time as the pixel voltage Vpix. A difference voltage between the pixel voltage Vpix and the reset voltage Vreset corresponds to a received light amount of the light-receiving pixel P during the exposure period T. In such a manner, the light-receiving pixel P outputs the signal SIG including the reset voltage Vreset and the pixel voltage Vpix to the signal line VSL.

The pixel block 100R (FIG. 5) includes eight photodiodes, eight transistors TRG, four floating diffusion layers, and one transistor RST, one transistor AMP and one transistor SEL, each as a pixel transistor. The eight photodiodes and the eight transistors TRG each respectively correspond to the eight light-receiving pixels PR included in the pixel block 100R. The gates of the eight transistors TRG are coupled to respective different control lines TRGL among the eight control lines TRGL (in this example, the control lines TRGL1, TRGL2, and TRGL5 to TRGL10). In the same manner as the pixel block 100Gr, the four floating diffusion layers are arranged one by one for the respective pixel pairs 90A, and each of the four floating diffusion layers is shared by the two light-receiving pixels P constituting the pixel pair 90A and being adjacent to each other in the X-axis direction. The four floating diffusion layers and the transistors TRG, RST, AMP, and SEL are each provided on the front surface 111S1 of the semiconductor substrate 111.

In the same manner as the pixel block 100R (FIG. 5), the pixel block 100B includes eight photodiodes, eight transistors TRG, four floating diffusion layers, and one transistor RST, one transistor AMP and one transistor SEL, each as a pixel transistor. The eight photodiodes and the eight transistors TRG each respectively correspond to the eight light-receiving pixels PB included in the pixel block 100B. The gates of the eight transistors TRG are coupled to respective different control lines TRGL among the eight control lines TRGL. In the same manner as the pixel block 100Gr, the four floating diffusion layers are arranged one by one for the respective pixel pairs 90A, and each of the four floating diffusion layers is shared by the two light-receiving pixels P constituting the pixel pair 90A and being adjacent to each other in the X-axis direction. The four floating diffusion layers and the transistors TRG, RST, AMP, and SEL are each provided on the front surface 111 S1 of the semiconductor substrate 111.

In the same manner as the pixel block 100Gr (FIG. 4), the pixel block 100Gb includes ten photodiodes, ten transistors TRG, five floating diffusion layers, and one transistor RST, one transistor AMP and one transistor SEL, each as a pixel transistor. The ten photodiodes and the ten transistors TRG each respectively correspond to the ten light-receiving pixels PGb included in the pixel block 100Gb. The gates of the ten transistors TRG are coupled to respective different control lines TRGL among the ten control lines TRGL. The five floating diffusion layers are arranged one by one for the respective pixel pairs 90A, and each of the five floating diffusion layers is shared by the two light-receiving pixels P constituting the pixel pair 90A and being adjacent to each other in the X-axis direction. The five floating diffusion layers and the transistors TRG, RST, AMP, and SEL are each provided on the front surface 111S1 of the semiconductor substrate 111.

FIG. 6 illustrates an example of a planar configuration in each of the plurality of light-receiving pixels P constituting the pixel blocks 100R, 100Gr, 100Gb, and 100B.

The five or four floating diffusion layers provided in each of the pixel blocks 100R, 100Gr, 100Gb, and 100B are shared by the two light-receiving pixels P constituting the pixel pair 90A and being adjacent to each other in the X-axis direction. Specifically, as illustrated in FIG. 6, the floating diffusion layer is disposed at a boundary between the two light-receiving pixels P constituting the pixel pair 90A and being adjacent to each other in the X-axis direction.

The ten or eight transistors TRG provided in each of the pixel blocks 100R, 100Gr, 100Gb, and 100B are provided one by one for the respective ten or eight light-receiving pixels P constituting each of the pixel blocks 100R, 100Gr, 100Gb, and 100B. For example, as illustrated in FIG. 6, the gates of the transistors TRG provided in the respective light-receiving pixels P are arranged to be opposed to each other along the X-axis direction, for each of the pixel pairs 90A, with the floating diffusion layer, which is arranged at the boundary between the two light-receiving pixels P adjacent to each other in the X-axis direction, being interposed therebetween.

The pixel transistor includes the transistors RST, AMP, and SEL, and one transistor RST, one transistor AMP and one transistor SEL are provided for each of the pixel blocks 100R, 100Gr, 100Gb, and 100B. In other words, a unit U including the pixel blocks 100R, 100Gr, 100Gb, and 100B includes 12 pixel transistors (RST-R, RST-Gr, RST-Gb, RST-B, AMP-R, AMP-Gr, AMP-Gb, AMP-B, SEL-R, SEL-Gr, SEL-Gb, and SEL-B). It is to be noted that R, Gr, Gb, and B attached to the end of each symbol of the pixel transistors correspond to the pixel blocks 100R, 100Gr, 100Gb, and 100B in which the respective pixel transistors are provided. In a case where the respective pixel transistors provided in the pixel blocks 100R, 100Gr, 100Gb, and 100B need not be distinguished from one another, R, Gr, Gb, and B attached to the end thereof are omitted.

The 12 pixel transistors are provided to be divided into three groups of four pixel transistors (e.g., [RST-Gr, RST-B/RST-R/RST-Gb]/ [AMP-Gr/SEL-Gr/SEL-R/AMP-R]/ [AMP-B/SEL-B/SEL-Gb/AMP-Gb]), for example. The four pixel transistors of each group are provided side by side, for example, along the X-axis direction. For example, as illustrated in FIG. 6, in a case where the one floating diffusion layer and the gates of the two transistors TRG arranged to be opposed to each other provided for each of the pixel pairs 90A are arranged to be one-sided toward one (e.g., a lower side on the sheet), of a pair of sides opposed to each other in the Y-axis direction, and toward the other side (e.g., an upper side on the sheet) thereof, on every other row, four pixel transistors of each group are provided side by side at the boundary between two light-receiving pixels P adjacent to each other in the Y-axis direction, e.g., at a position that overlaps with the pixel separation section 113 in a plan view. In such a manner, the four pixel transistors of each group at the boundary between two light-receiving pixels P adjacent to each other in the Y-axis direction are shared by the two light-receiving pixels P adjacent to each other in the Y-axis direction. This improves area efficiency. In addition, the four pixel transistors of each group are arranged cyclically in each of the X-axis direction and the Y-axis direction. A cycle in the X-axis direction is larger than a cycle in the Y-axis direction, and is twice larger, for example.

Element separation sections 115 and 116 are provided, in a plan view, above and below the plurality of pixel transistors provided side by side along the X-axis direction and between the plurality of pixel transistors provided side by side, respectively. The element separation section 115 electrically separates a diffusion region 114 and the light-receiving section 112 from each other. The diffusion region 114, in which N-type impurities are diffused, is provided on the front surface 111S1 of the semiconductor substrate 111 constituting the source/drain of the transistors TRG, RST, AMP, and SEL. The element separation section 115 extends along the four pixel transistors of each group provided side by side along the above-described X-axis direction. The element separation section 116 electrically separates the plurality of pixel transistors provided side by side, as appropriate, from each other. The element separation sections 115 and 116 are each provided, as an STI (Shallow Trench Isolation) formed using an insulating layer, for example, on the front surface 111 S1 of the semiconductor substrate 111.

A well contact region WellCon for applying fixed electric charge to the semiconductor substrate 111 is provided between pixel transistors provided side by side for each of the pixel blocks 100R, 100Gr, 100Gb, and 100B. For example, as illustrated in FIG. 6, the well contact region WellCon is provided at a position that overlaps with an intersection of the pixel separation section 113 extending in the X-axis direction and the Y-axis direction in a plan view.

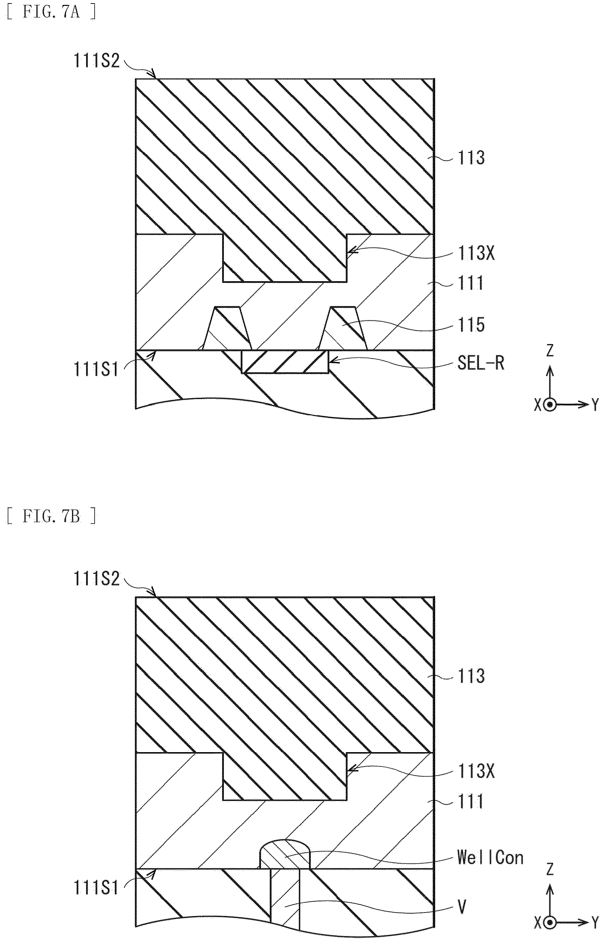

FIG. 7A illustrates an example of a cross-sectional configuration of the semiconductor substrate 111 and the multilayer wiring layer 121 near the front surface 111S1 of the semiconductor substrate 111 corresponding to a line II-II' illustrated in FIG. 6. FIG. 7B illustrates an example of a cross-sectional configuration of the semiconductor substrate 111 and the multilayer wiring layer 121 near the front surface 111S1 of the semiconductor substrate 111 corresponding to a line III-III' illustrated in FIG. 6. At and near the intersection of the pixel separation section 113 extending in the X-axis direction and the Y-axis direction, the pixel separation section 113 protrudes closer to a side of the front surface 111S1 than the pixel separation section 113 in another region (a projecting part 113X). The protrusion is caused by the inflow of an etching gas upon formation of a groove constituting the pixel separation section 113. The projecting part 113X of the pixel separation section 113 applies greater stress to the semiconductor substrate 111 than the pixel separation section 113 in the other region.

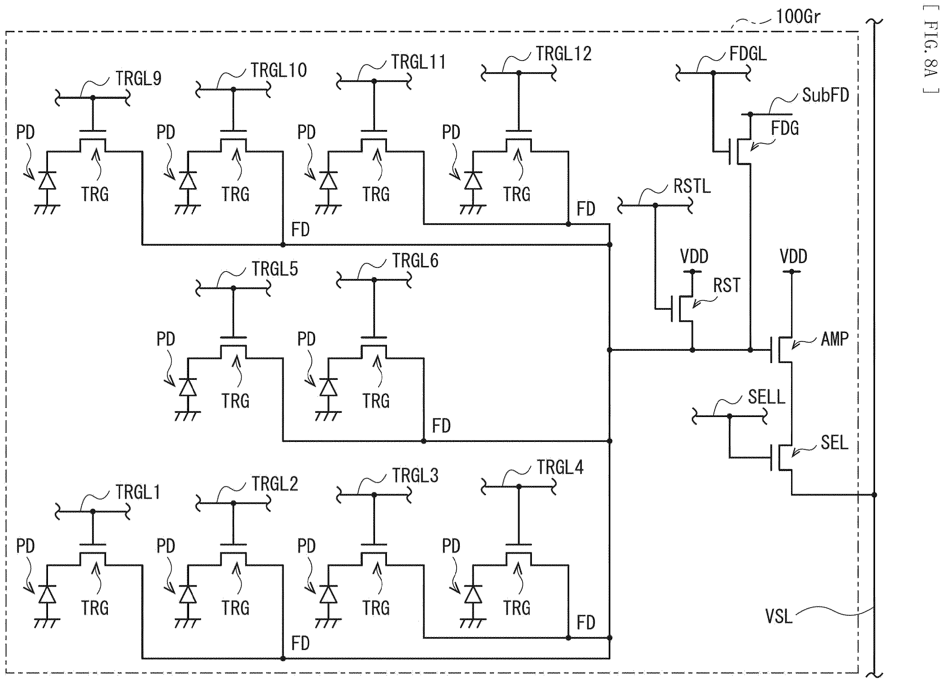

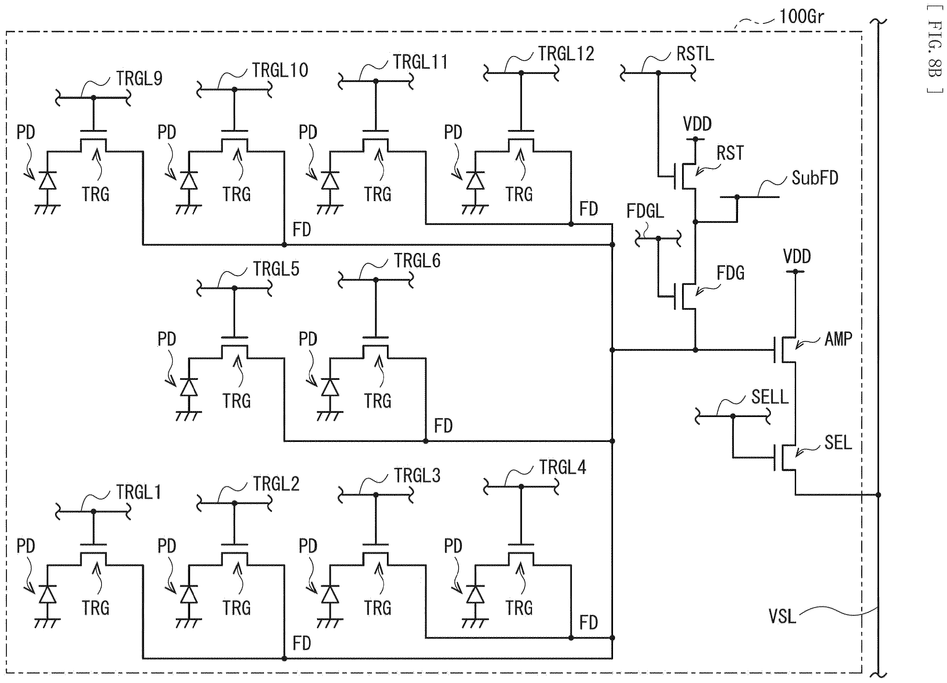

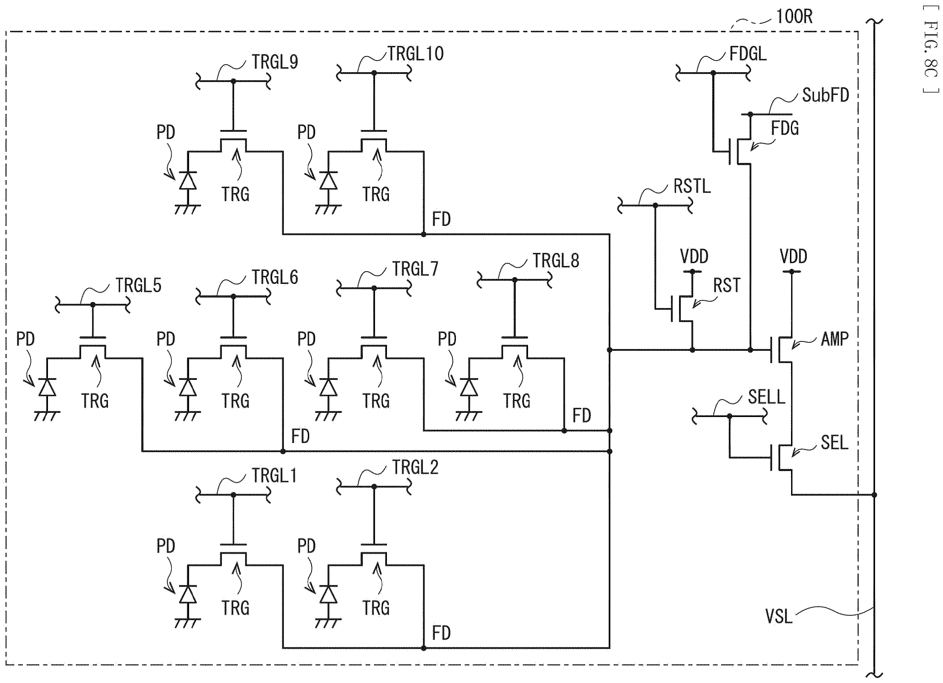

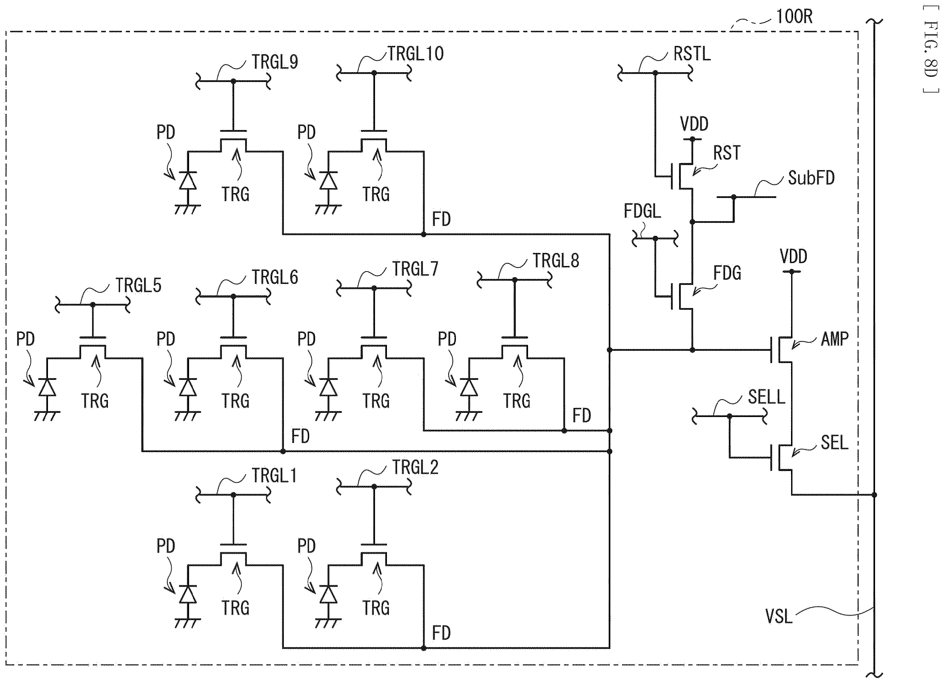

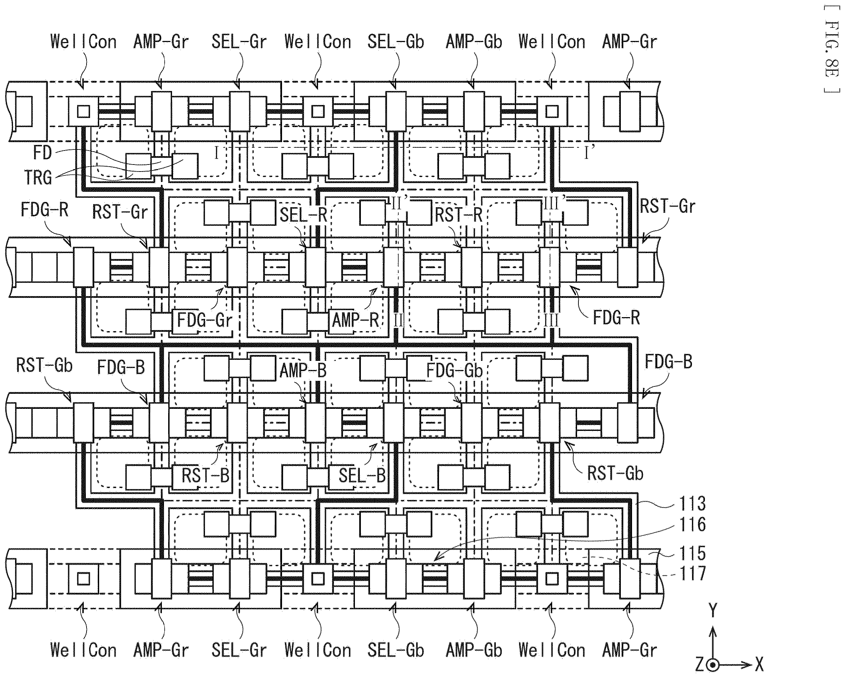

In the present embodiment, as illustrated in FIG. 6, the plurality of pixel transistors provided side by side along the X-axis direction is surrounded by the element separation section 115 for each well contact region WellCon provided therebetween. In other words, the element separation section 115 extending along the plurality of pixel transistors provided side by side along the X-axis direction as illustrated in FIGs. 6 and 7 is divided at the intersection of the pixel separation section 113 extending in the X-axis direction and the Y-axis direction, as illustrated in FIGs. 6 and 8. This relieves stress to be applied to the semiconductor substrate 111 at the projecting part 113X of the pixel separation section 113. An impurity layer 117 is provided, in a plan view, above and below the well contact region WellCon on the extension of the element separation section 115 extending along the X-axis direction. The impurity layer 117 electrically separates the well contact region WellCon and the light-receiving section 112 from each other.

It is to be noted that the diffusion region 114 may be shared by pixel transistors provided side by side. This makes it possible to reduce an area for the formation of pixel transistors. Further, as illustrated in FIGs. 8A to 8E, a transistor FDG may be further provided as the plurality of pixel transistors constituting a readout circuit in order to switch conversion efficiencies. FIG. 8A illustrates an example of a configuration of the pixel block 100Gr upon addition of the transistor FDG. FIG. 8B illustrates another example of the configuration of the pixel block 100Gr upon the addition of the transistor FDG. FIG. 8C illustrates an example of a configuration of the pixel block 100R upon the addition of the transistor FDG. FIG. 8D illustrates another example of the configuration of the pixel block 100R upon the addition of the transistor FDG. FIG. 8E illustrates an example of a planar configuration in each of the plurality of light-receiving pixels P constituting the pixel blocks 100R, 100Gr, 100Gb, and 100B upon the addition of the transistor FDG.

The drive section 12 (FIG. 1) is configured to drive the plurality of light-receiving pixels P in the pixel array 11 on the basis of instructions from the imaging control section 18. Specifically, the drive section 12 drives the plurality of light-receiving pixels P in the pixel array 11 by supplying the plurality of control signals STRG respectively to the plurality of control lines TRGL, supplying the plurality of control signals SRST respectively to the plurality of control lines RSTL, and supplying the plurality of control signals SSEL respectively to the plurality of control lines SELL in the pixel array 11.

The reference signal generation section 13 is configured to generate a reference signal RAMP on the basis of instructions from the imaging control section 18. The reference signal RAMP has a so-called ramp waveform in which a voltage level gradually changes with a lapse of time during periods during which the readout section 20 performs AD conversion (the P-phase period TP and the D-phase period TD). The reference signal generation section 13 supplies such a reference signal RAMP to the readout section 20.

The readout section 20 is configured to generate an image signal SpicO on the basis of instructions from the imaging control section 18 by performing AD conversion on the basis of the signal SIG supplied from the pixel array 11 via the signal line VSL.

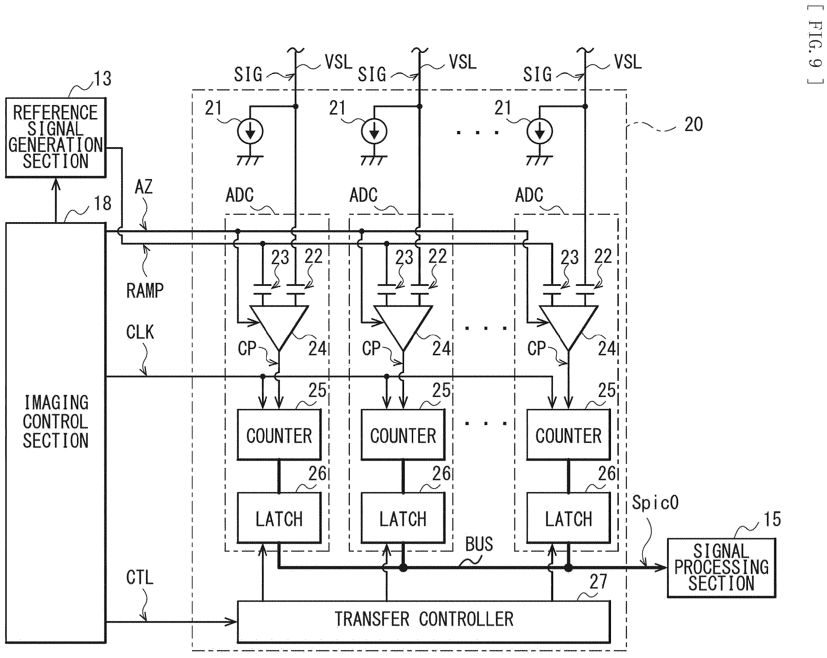

FIG. 9 illustrates a configuration example of the readout section 20. It is to be noted that FIG. 9 also illustrates the reference signal generation section 13, the signal processing section 15, and the imaging control section 18 in addition to the readout section 20. The readout section 20 includes a plurality of constant current sources 21, a plurality of AD (Analog to Digital) converters ADC, and a transfer controller 27. The plurality of constant current sources 21 and the plurality of AD converters ADC are provided in correspondence with the plurality of respective signal lines VSL. In the following, description is given of the constant current source 21 and the AD converter ADC corresponding to one signal line VSL.

The constant current source 21 is configured to feed a predetermined current through the corresponding signal line VSL. The constant current source 21 has one end coupled to the corresponding signal line VSL and another end grounded.

The AD converter ADC is configured to perform AD conversion on the basis of the signal SIG on the corresponding signal line VSL. The AD converter ADC includes capacitors 22 and 23, a comparison circuit 24, a counter 25, and a latch 26.

The capacitor 22 has one end coupled to the signal line VSL and is to be supplied with the signal SIG, and another end coupled to the comparison circuit 24. The capacitor 23 has one end to be supplied with the reference signal RAMP supplied from the reference signal generation section 13, and another end coupled to the comparison circuit 24.

The comparison circuit 24 is configured to generate a signal CP by performing comparison operations on the basis of the signal SIG supplied from the light-receiving pixel P via the signal line VSL and the capacitor 22 and the reference signal RAMP supplied from the reference signal generation section 13 via the capacitor 23. The comparison circuit 24 sets an operating point by setting voltages of the capacitors 22 and 23 on the basis of a control signal AZ supplied from the imaging control section 18. In addition, the comparison circuit 24 thereafter performs a comparison operation of comparing the reset voltage Vreset included in the signal SIG and the voltage of the reference signal RAMP during the P-phase period TP, and performs a comparison operation of comparing the pixel voltage Vpix included in the signal SIG and the voltage of the reference signal RAMP during the D-phase period TD.

The counter 25 is configured to perform a counting operation of counting pulses of a clock signal CLK supplied from the imaging control section 18 on the basis of the signal CP supplied from the comparison circuit 24. Specifically, during the P-phase period TP, the counter 25 generates a count value CNTP by counting the pulses of the clock signal CLK until the signal CP transitions, and outputs the count value CNTP as a digital code having a plurality of bits. In addition, during the D-phase period TD, the counter 25 generates a count value CNTD by counting the pulses of the clock signal CLK until the signal CP transitions, and outputs the count value CNTD as a digital code having a plurality of bits.

The latch 26 is configured to temporarily hold the digital codes supplied from the counter 25 and to output the digital codes to a bus wiring line BUS on the basis of instructions from the transfer controller 27.

The transfer controller 27 is configured to perform control on the basis of a control signal CTL supplied from the imaging control section 18 to cause the latches 26 of the plurality of AD converters ADC to sequentially output the digital codes to the bus wiring line BUS. The readout section 20 uses this bus wiring line BUS to sequentially transfer, as the image signals SpicO, the plurality of digital codes supplied from the plurality of AD converters ADC to the signal processing section 15.

The signal processing section 15 (FIG. 1) is configured to generate an image signal Spic by performing predetermined signal processing on the basis of the image signal SpicO and instructions from the imaging control section 18. The signal processing section 15 includes an image data generator 16 and a phase difference data generator 17. The image data generator 16 is configured to generate image data DP representing a captured image by performing predetermined image processing on the basis of the image signal SpicO. The phase difference data generator 17 is configured to generate phase difference data DF representing an image-plane phase difference by performing predetermined image processing on the basis of the image signal SpicO. The signal processing section 15 generates the image signal Spic including the image data DP generated by the image data generator 16 and the phase difference data DF generated by the phase difference data generator 17.

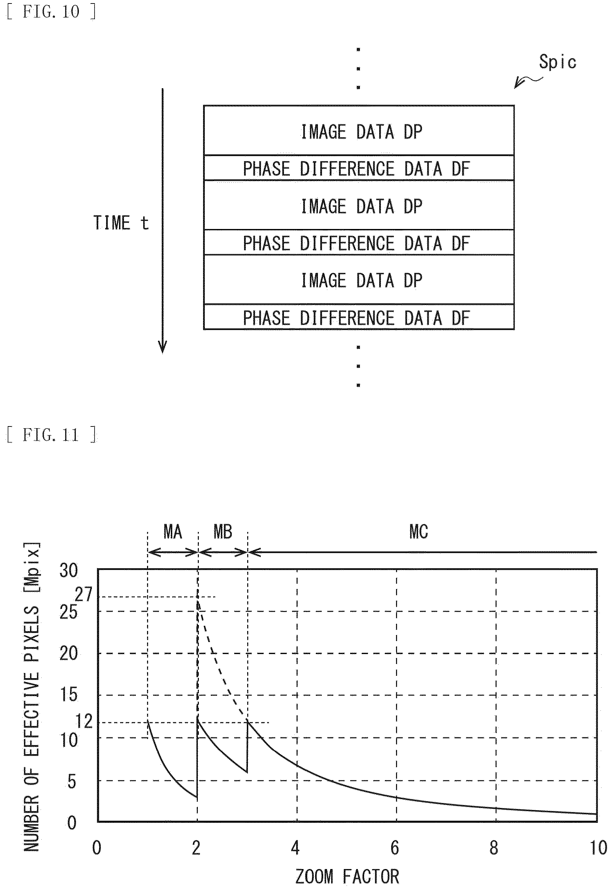

FIG. 10 illustrates an example of the image signal Spic. The signal processing section 15 generates the image signal Spic by, for example, alternately arranging the image data DP for a plurality of rows of light-receiving pixels P and the phase difference data DF for a plurality of rows of light-receiving pixels P. The signal processing section 15 then outputs such an image signal Spic.

The imaging control section 18 is configured to control the operation of the imaging device 1 by supplying control signals to the drive section 12, the reference signal generation section 13, the readout section 20, and the signal processing section 15 and controlling the operations of these circuits. The imaging control section 18 is to be supplied with a control signal Sctl from an external source. The control signal Sctl includes, for example, information about a zoom factor of a so-called electronic zoom. The imaging control section 18 controls the operation of the imaging device 1 on the basis of the control signal Sctl.

### [Operation]

Subsequently, description is given of the operation of the imaging device 1 according to the present embodiment.

### (Overview of Overall Operation)

First, an overview of an overall operation of the imaging device 1 is described with reference to FIGs. 1 and 9. The drive section 12 subsequentially drives the plurality of light-receiving pixels P in the pixel array 11 on the basis of instructions from the imaging control section 18. The reference signal generation section 13 generates the reference signal RAMP on the basis of instructions from the imaging control section 18. The light-receiving pixel P outputs the reset voltage Vreset as the signal SIG during the P-phase period TP, and outputs the pixel voltage Vpix corresponding to a received light amount as the signal SIG during the D-phase period TD. The readout section 20 generates the image signal SpicO on the basis of the signal SIG supplied from the pixel array 11 via the signal line VSL and instructions from the imaging control section 18. In the signal processing section 15, the image data generator 16 generates the image data DP representing a captured image by performing predetermined image processing on the basis of the image signal SpicO, and the phase difference data generator 17 generates the phase difference data DF representing the image-plane phase difference by performing predetermined image processing on the basis of the image signal SpicO. Then, the signal processing section 15 generates the image signal Spic including the image data DP and the phase difference data DF. The imaging control section 18 controls the operation of the imaging device 1 by supplying control signals to the drive section 12, the reference signal generation section 13, the readout section 20, and the signal processing section 15 and controlling the operations of these circuits.

### (Detailed Operation)

The imaging control section 18 controls the operation of the imaging device 1 on the basis of the control signal Sctl including the information about the zoom factor of the electronic zoom. A description is given below of a zoom operation of the imaging device 1.

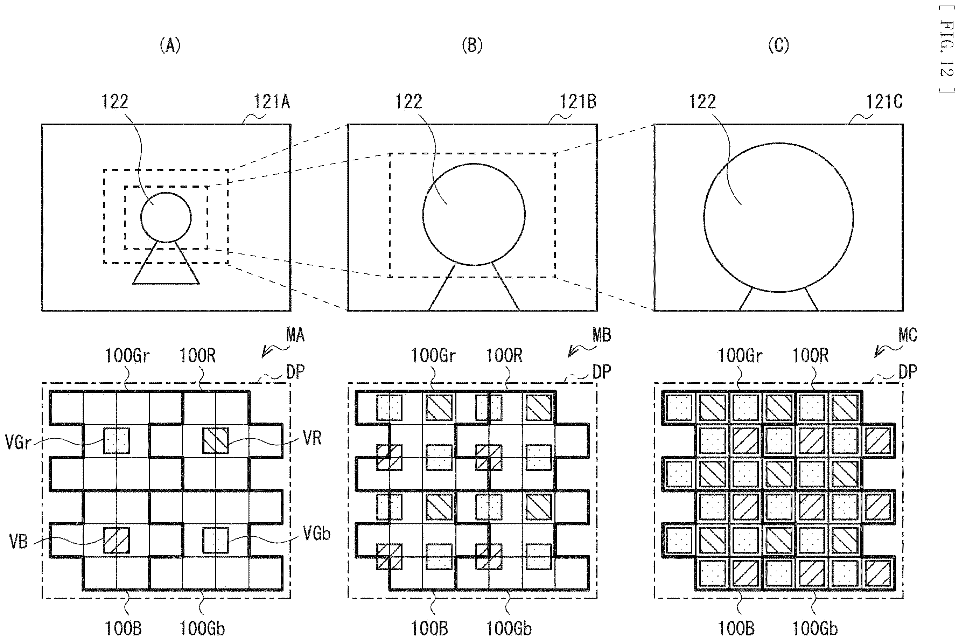

FIG. 11 illustrates an example of the number of the light-receiving pixels P pertaining to a captured image (the number of effective pixels) in a case where the zoom factor is varied from 1x to 10x. In FIG. 11, the solid line represents the number of effective pixels of the imaging device 1. FIG. 12 illustrates an example of the zoom operation of the imaging device 1, in which (A) illustrates an operation in a case where the zoom factor is 1x, (B) illustrates an operation in a case where the zoom factor is 2x, and (C) illustrates an operation in a case where the zoom factor is 3x.

The imaging device 1 has three imaging modes M (imaging modes MA, MB, and MC). The imaging control section 18 selects one of the three imaging modes MA to MC on the basis of the information about the zoom factor included in the control signal Sctl. Specifically, as illustrated in FIG. 11, the imaging control section 18 selects the imaging mode MA in a case where the zoom factor is less than 2, selects the imaging mode MB in a case where the zoom factor is 2 or more and less than 3, and selects the imaging mode MC in a case where the zoom factor is 3 or more.

In the imaging mode MA, as illustrated in (A) of FIG. 12, the imaging device 1 obtains four pixel values V (pixel values VR, VGr, VGb, and VB) for each of a plurality of units or units U. Specific operations are described later. In such a manner, the imaging device 1 generates the image data DP by generating the pixel values V with a ratio of four pixel values V to 36 light-receiving pixels P. In a case where the number of the light-receiving pixels P in the pixel array 11 is 108 [Mpix], the pixel values V are calculated for 12 [Mpix]. Thus, as illustrated in FIG. 11, the number of effective pixels is 12 [Mpix].

As illustrated in FIG. 11, when the zoom factor is increased from one in the imaging mode MA, the number of effective pixels decreases in accordance with the factor. Then, when the zoom factor reaches two, the imaging mode M turns into the imaging mode MB.

In the imaging mode MB, as illustrated in (B) of FIG. 12, the imaging device 1 obtains 16 pixel values V for each of the plurality of units or units U. Specific operations are described later. In such a manner, the imaging device 1 generates the image data DP by generating the pixel values V with a ratio of 16 pixel values V to 36 light-receiving pixels P. In the case where the number of the light-receiving pixels P in the pixel array 11 is 108 [Mpix], the pixel values V are calculated for 48 [Mpix]. In actuality, because the zoom factor is 2x, the imaging range is reduced to 1/4 as illustrated in (B) of FIG. 12, and the number of effective pixels is thus 12 [Mpix] (= 48 [Mpix]/4).

As illustrated in FIG. 11, when the zoom factor is increased from two in the imaging mode MB, the number of effective pixels decreases in accordance with the factor. Then, when the zoom factor reaches three, the imaging mode M turns into the imaging mode MC.

In the imaging mode MC, as illustrated in (C) of FIG. 12, the imaging device 1 obtains 36 pixel values V for each of the plurality of units or units U. Specific operations are described later. In such a manner, the imaging device 1 generates the image data DP by generating the pixel values V with a ratio of 36 pixel values V to 36 light-receiving pixels P. In the case where the number of the light-receiving pixels P in the pixel array 11 is 108 [Mpix], it is possible to obtain a captured image of 108 [Mpix]. In actuality, because the zoom factor is 3x, the imaging range is reduced to 1/9 as illustrated in (C) of FIG. 12, and the number of effective pixels is thus 12 [Mpix] (= 108 [Mpix]/9).

As described above, the imaging device 1 is provided with the three imaging modes M, and it is therefore possible to reduce a change in the image quality of a captured image in a case where the zoom factor is changed. That is, for example, in a case where the imaging mode MB is omitted and the two imaging modes MA and MC are provided, selecting the imaging mode MA in a case where the zoom factor is less than 2x and selecting the imaging mode MC in a case where the zoom factor is 2x or more result in a large change in the number of effective pixels, as illustrated in broken lines in FIG. 11. That is, in this example, in a case where the zoom factor is 2x, the imaging mode MC is selected, and the number of effective pixels is 27 [Mpix] (= 108 [Mpix]/4). Therefore, a large difference occurs between the number of effective pixels in a case where the zoom factor is, for example, 1.9x and the number of effective pixels in the case where the zoom factor is 2x. This can result in a large change in the image quality of a captured image at a zoom factor of around 2x. In contrast, the imaging device 1 is provided with the three imaging modes M, and is thus able to reduce a change in the number of effective pixels in the case of changing the zoom factor. This makes it possible to suppress a change in the image quality of a captured image.

### (Imaging Mode MA)

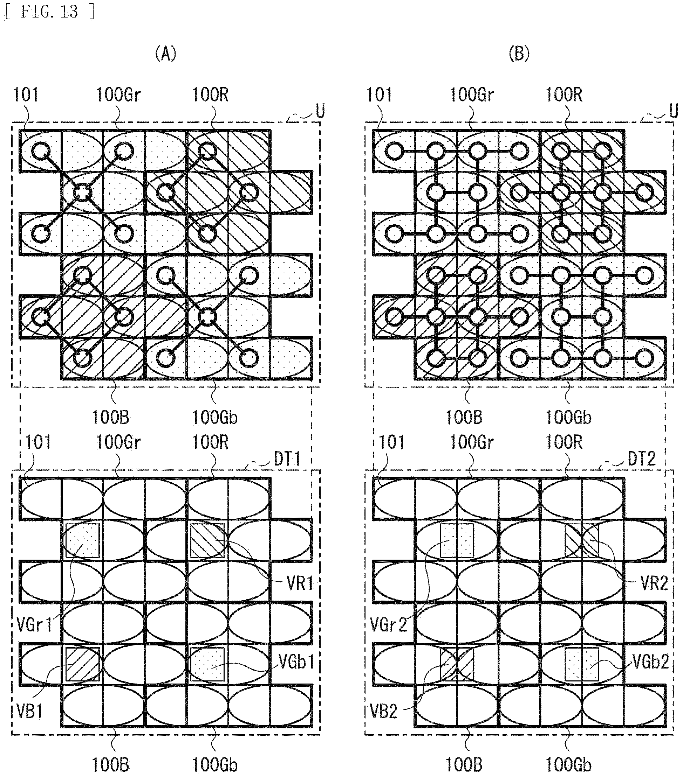

FIG. 13 illustrates an operation example of the imaging device 1 in the imaging mode MA. In FIG. 13, the light-receiving pixels P illustrated with "o" represent the light-receiving pixels P that are targeted for the readout operation.

First, as illustrated in (A) of FIG. 13, the imaging device 1 generates image data DT1 by calculating a pixel value V corresponding to a received light amount of the left light-receiving pixels P in the pixel pairs 90A provided with the lenses 101 in each of the plurality of pixel blocks 100. Specifically, among the ten light-receiving pixels PGr in the pixel block 100Gr, the imaging device 1 targets the five light-receiving pixels PGr arranged on the left in the five pixel pairs 90A for the readout operation, and thus calculates a pixel value VGr1 at a centroid position of the five light-receiving pixels PGr. In addition, among the eight light-receiving pixels PR in the pixel block 100R, the imaging device 1 targets the four light-receiving pixels PR arranged on the left in the four pixel pairs 90A for the readout operation, and thus calculates a pixel value VR1 at a centroid position of the four light-receiving pixels PR. Among the eight light-receiving pixels PB in the pixel block 100B, the imaging device 1 targets the four light-receiving pixels PB arranged on the left in the four pixel pairs 90A for the readout operation, and thus calculates a pixel value VB1 at a centroid position of the four light-receiving pixels PB. Among the ten light-receiving pixels PGb in the pixel block 100Gb, the imaging device 1 targets the five light-receiving pixels PGb arranged on the left in the five pixel pairs 90A for the readout operation, and thus calculates a pixel value VGb1 at a centroid position of the five light-receiving pixels PGb. In such a manner, the imaging device 1 generates the image data DT1 ((A) of FIG. 13) including the pixel values VGr1, VR1, VB1, and VGb1.

Next, as illustrated in (B) of FIG. 13, the imaging device 1 generates image data DT2 by calculating pixel values V corresponding to received light amounts of all of the light-receiving pixels P in each of the plurality of pixel blocks 100. Specifically, the imaging device 1 targets the ten light-receiving pixels PGr in the pixel block 100Gr for the readout operation, and thus calculates a pixel value VGr2 at a centroid position of the ten light-receiving pixels PGr. Further, the imaging device 1 targets the eight light-receiving pixels PR in the pixel block 100R for the readout operation, and thus calculates a pixel value VR2 at a centroid position of the eight light-receiving pixels PR. The imaging device 1 targets the eight light-receiving pixels PB in the pixel block 100B for the readout operation, and thus calculates a pixel value VB2 at a centroid position of the eight light-receiving pixels PB. The imaging device 1 targets the ten light-receiving pixels PGb in the pixel block 100Gb for the readout operation, and thus calculates a pixel value VGb2 at a centroid position of the ten light-receiving pixels PGb. In such a manner, the imaging device 1 generates the image data DT2 ((B) of FIG. 13) including the pixel values VGr2, VR2, VB2, and VGb2.

With attention focused on the certain pixel block 100Gr, description is given below of the readout operation on the ten light-receiving pixels PGr in the pixel block 100Gr.

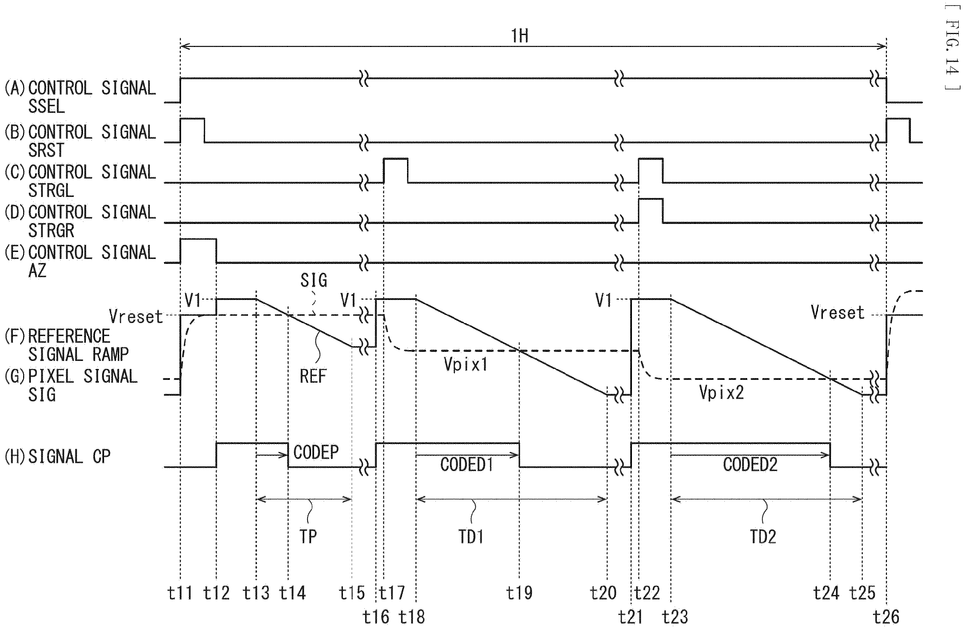

FIG. 14 illustrates an example of the readout operation, in which (A) illustrates a waveform of the control signal SSEL, (B) illustrates a waveform of the control signal SRST, (C) illustrates a waveform of the control signal STRG (a control signal STRGL) supplied to the light-receiving pixel PGr arranged on the left in the pixel pair 90A, (D) illustrates a waveform of the control signal STRG (a control signal STRGR) supplied to the light-receiving pixel PGr arranged on the right in the pixel pair 90A, (E) illustrates a waveform of the control signal AZ, (F) illustrates a waveform of the reference signal RAMP, (G) illustrates a waveform of the signal SIG, and (H) illustrates a waveform of the signal CP. In (F) and (G) of FIG. 14, the waveforms of the reference signal RAMP and the signal SIG are illustrated using the same voltage axis. In addition, in this description, the waveform of the reference signal RAMP illustrated in (F) of FIG. 14 is the waveform of a voltage supplied to an input terminal of the comparison circuit 24 via the capacitor 23, and the waveform of the signal SIG illustrated in (G) of FIG. 14 is the waveform of a voltage supplied to the input terminal of the comparison circuit 24 via the capacitor 22.

First, a horizontal period H starts at a timing t11. The drive section 12 thus changes the voltage of the control signal SSEL from the low level to the high level ((A) of FIG. 14). This brings the transistor SEL into an ON state in the pixel block 100Gr, and causes the pixel block 100Gr to be electrically coupled to the signal line VSL. In addition, at this timing t11, the drive section 12 changes the voltage of the control signal SRST from the low level to the high level ((B) of FIG. 14). This brings the transistor RST into an ON state in the pixel block 100Gr, and causes the voltage of the floating diffusion layer to be set to the power supply voltage VDD (a reset operation). Then, the pixel block 100Gr outputs a voltage corresponding to the voltage of the floating diffusion layer at this time. In addition, at this timing t11, the imaging control section 18 changes the voltage of the control signal AZ from the low level to the high level ((E) of FIG. 14). This causes the comparison circuit 24 of the AD converter ADC to set the operating point by setting the voltages of the capacitors 22 and 23. In such a manner, the voltage of the signal SIG is set to the reset voltage Vreset, and the voltage of the reference signal RAMP is set to the same voltage as the voltage of the signal SIG (the reset voltage Vreset) ((F) and (G) of FIG. 14).

Then, at a timing at which a predetermined time has elapsed from the timing t11, the drive section 12 changes the voltage of the control signal SRST from the high level to the low level ((B) of FIG. 14). This brings the transistor RST into an OFF state in the pixel block 100Gr, and causes the reset operation to end.

Next, at a timing t12, the imaging control section 18 changes the voltage of the control signal AZ from the high level to the low level ((E) of FIG. 14). This causes the comparison circuit 24 to end the setting of the operating point.

Further, at this timing t12, the reference signal generation section 13 sets the voltage of the reference signal RAMP to a voltage V1 ((F) of FIG. 14). This makes the voltage of the reference signal RAMP higher than the voltage of the signal SIG. The comparison circuit 24 thus changes the voltage of the signal CP from the low level to the high level ((H) of FIG. 14).

Then, during a period from a timing t13 to a timing t15 (P-phase period TP), the AD converter ADC performs AD conversion on the basis of the signal SIG. Specifically, first, at the timing t13, the reference signal generation section 13 starts decreasing the voltage of the reference signal RAMP from the voltage V1 at a predetermined change rate ((F) of FIG. 14). In addition, at this timing t13, the imaging control section 18 starts generating the clock signal CLK. The counter 25 of the AD converter ADC performs the counting operation to thereby count the pulses of the clock signal CLK.

Then, at a timing t14, the voltage of the reference signal RAMP falls below the voltage of the signal SIG (the reset voltage Vreset) ((F) and (G) of FIG. 14). The comparison circuit 24 of the AD converter ADC thus changes the voltage of the signal CP from the high level to the low level ((H) of FIG. 14). The counter 25 of the AD converter ADC stops the counting operation on the basis of the transition of the signal CP. The count value (count value CNTP) of the counter 25 at this time is a value corresponding to the reset voltage Vreset. The latch 26 holds this count value CNTP. The counter 25 then resets the count value.

Next, at the timing t15, the imaging control section 18 stops generating the clock signal CLK at the end of the P-phase period TP. In addition, the reference signal generation section 13 stops changing the voltage of the reference signal RAMP at this timing t15 ((F) of FIG. 14). Then, during a period from the timing t15 forward, the readout section 20 supplies, as the image signal SpicO, the count value CNTP held by the latch 26 to the signal processing section 15.

Next, at a timing t16, the imaging control section 18 sets the voltage of the reference signal RAMP to the voltage V1 ((F) of FIG. 14). This makes the voltage of the reference signal RAMP higher than the voltage of the signal SIG (the reset voltage Vreset). The comparison circuit 24 thus changes the voltage of the signal CP from the low level to the high level ((H) of FIG. 14).

Next, at a timing t17, the drive section 12 changes the voltage of the control signal STRGL from the low level to the high level ((C) of FIG. 14). This brings the transistors TRG into an ON state in the five light-receiving pixels PGr arranged on the left in the pixel pairs 90A, and causes the electric charge generated at the photodiodes to be transferred to the floating diffusion layer (an electric charge transfer operation). Then, the pixel block 100Gr outputs a voltage corresponding to the voltage of the floating diffusion layer at this time. In such a manner, the voltage of the signal SIG becomes a pixel voltage Vpix1 ((G) of FIG. 14).

Then, at a timing at which a predetermined time has elapsed from the timing t17, the drive section 12 changes the voltage of the control signal STRGL from the high level to the low level ((C) of FIG. 14). This brings the transistors TRG into an OFF state in the five light-receiving pixels PGr arranged on the left in the pixel pairs 90A, and causes the electric charge transfer operation to end.

Then, during a period from a timing t18 to a timing t20 (D-phase period TD1), the AD converter ADC performs AD conversion on the basis of the signal SIG. Specifically, first, at the timing t18, the reference signal generation section 13 starts decreasing the voltage of the reference signal RAMP from the voltage V1 at a predetermined change rate ((F) of FIG. 14). In addition, at this timing t18, the imaging control section 18 starts generating the clock signal CLK. The counter 25 of the AD converter ADC performs the counting operation to thereby count the pulses of the clock signal CLK.

Then, at a timing t19, the voltage of the reference signal RAMP falls below the voltage of the signal SIG (the pixel voltage Vpix1) ((F) and (G) of FIG. 14). The comparison circuit 24 of the AD converter ADC thus changes the voltage of the signal CP from the high level to the low level ((H) of FIG. 14). The counter 25 of the AD converter ADC stops the counting operation on the basis of the transition of the signal CP. The count value (count value CNTD1) of the counter 25 at this time is a value corresponding to the pixel voltage Vpix1. The latch 26 holds this count value CNTD1. The counter 25 then resets the count value.

Next, at the timing t20, the imaging control section 18 stops generating the clock signal CLK at the end of the D-phase period TD1. In addition, the reference signal generation section 13 stops changing the voltage of the reference signal RAMP at this timing t20 ((F) of FIG. 14). Then, during a period from the timing t20 forward, the readout section 20 supplies, as the image signal SpicO, the count value CNTD1 held by the latch 26 to the signal processing section 15.

Next, at a timing t21, the imaging control section 18 sets the voltage of the reference signal RAMP to the voltage V1 ((F) of FIG. 14). This makes the voltage of the reference signal RAMP higher than the voltage of the signal SIG (the pixel voltage Vpix1). The comparison circuit 24 thus changes the voltage of the signal CP from the low level to the high level ((H) of FIG. 14).

Next, at a timing t22, the drive section 12 changes the respective voltages of the control signals STRGL and STRGR from the low level to the high level ((C) and (D) of FIG. 14). This brings the transistors TRG into an ON state in the ten light-receiving pixels PGr in the pixel block 100Gr, and causes the electric charge generated at the photodiodes to be transferred to the floating diffusion layer (the electric charge transfer operation). Then, the pixel block 100Gr outputs a voltage corresponding to the voltage of the floating diffusion layer at this time. In such a manner, the voltage of the signal SIG becomes a pixel voltage Vpix2 ((G) of FIG. 14).

Then, at a timing at which a predetermined time has elapsed from the timing t22, the drive section 12 changes the respective voltages of the control signals STRGL and STRGR from the high level to the low level ((C) and (D) of FIG. 14). This brings the transistors TRG into an OFF state in the ten light-receiving pixels PGr, and causes the electric charge transfer operation to end.

Then, during a period from a timing t23 to a timing t25 (D-phase period TD2), the AD converter ADC performs AD conversion on the basis of the signal SIG. Specifically, first, at the timing t23, the reference signal generation section 13 starts decreasing the voltage of the reference signal RAMP from the voltage V1 at a predetermined change rate ((F) of FIG. 14). In addition, at this timing t23, the imaging control section 18 starts generating the clock signal CLK. The counter 25 of the AD converter ADC performs the counting operation to thereby count the pulses of the clock signal CLK.

Then, at a timing t24, the voltage of the reference signal RAMP falls below the voltage of the signal SIG (the pixel voltage Vpix2) ((F) and (G) of FIG. 14). The comparison circuit 24 of the AD converter ADC thus changes the voltage of the signal CP from the high level to the low level ((H) of FIG. 14). The counter 25 of the AD converter ADC stops the counting operation on the basis of the transition of the signal CP. The count value (count value CNTD2) of the counter 25 at this time is a value corresponding to the pixel voltage Vpix2. The latch 26 holds this count value CNTD2. The counter 25 then resets the count value.

Next, at the timing t25, the imaging control section 18 stops generating the clock signal CLK at the end of the D-phase period TD2. In addition, the reference signal generation section 13 stops changing the voltage of the reference signal RAMP at this timing t25 ((F) of FIG. 14). Then, during a period from the timing t25 forward, the readout section 20 supplies, as the image signal SpicO, the count value CNTD2 held by the latch 26 to the signal processing section 15.

Next, at a timing t26, the drive section 12 changes the voltage of the control signal SSEL from the high level to the low level ((A) of FIG. 14). This brings the transistor SEL into an OFF state in the pixel block 100Gr, and causes the pixel block 100Gr to be electrically decoupled from the signal line VSL.

In such a manner, the readout section 20 supplies the image signal SpicO including the count values CNTP, CNTD1, and CNTD2 to the signal processing section 15. The signal processing section 15 generates the pixel value VGr1 illustrated in (A) of FIG. 13 and the pixel value VGr2 illustrated in (B) of FIG. 13 by utilizing the principle of correlated double sampling on the basis of the count values CNTP, CNTD1, and CNTD2 included in the image signals SpicO, for example. Specifically, the signal processing section 15 generates the pixel value VGr1 by, for example, subtracting the count value CNTP from the count value CNTD1. Because the count value CNTD 1 is a value corresponding to the sum of received light amounts at the five light-receiving pixels PGr arranged on the left in the five pixel pairs 90A in the pixel block 100Gr, the signal processing section 15 is able to generate the pixel value VGr1 illustrated in (A) of FIG. 13 on the basis of the count value CNTD1. Likewise, the signal processing section 15 generates the pixel value VGr2 by, for example, subtracting the count value CNTP from the count value CNTD2. Because the count value CNTD2 is a value corresponding to the sum of received light amounts at the ten light-receiving pixels PGr in the pixel block 100Gr, the signal processing section 15 is able to generate the pixel value VGr2 illustrated in (B) of FIG. 13 on the basis of the count value CNTD2.

Although the description has been given above of the pixel block 100Gr, the same applies to the pixel blocks 100R, 100Gb, and 100B. In such a manner, as illustrated in FIG. 13, the signal processing section 15 generates the image data DT1 including the pixel values VR1, VGr1, VGb1, and VB1 and the image data DT2 including the pixel values VR2, VGr2, VGb2, and VB2.

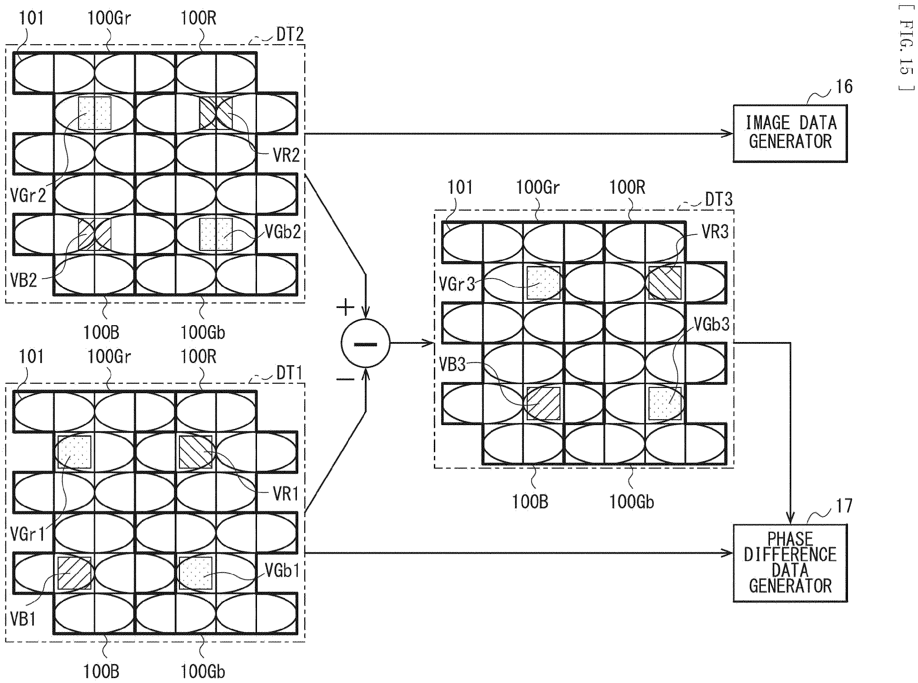

FIG. 15 illustrates an example of image processing by the signal processing section 15 in the imaging mode MA.

First, the signal processing section 15 generates image data DT3 by performing subtraction processing on the basis of the image data DT1 and DT2.

Specifically, the signal processing section 15 subtracts the pixel value VGr1 in the image data DT1 from the pixel value VGr2 in the image data DT2 to thereby calculate a pixel value VGr3. The pixel value VGr3 is a value corresponding to the sum of received light amounts at the five light-receiving pixels PGr arranged on the right in the five pixel pairs 90A in the pixel block 100Gr. That is, the pixel value VGr1 is a value corresponding to the sum of received light amounts at the five light-receiving pixels PGr arranged on the left in the five pixel pairs 90A in the pixel block 100Gr, and the pixel value VGr2 is a value corresponding to the sum of received light amounts at the ten light-receiving pixels PGr in the pixel block 100Gr. Therefore, subtracting the pixel value VGr1 from the pixel value VGr2 gives a value corresponding to the sum of received light amounts at the five light-receiving pixels PGr arranged on the right in the five pixel pairs 90A in the pixel block 100Gr. Because the pixel value VGr3 is the value corresponding to the sum of received light amounts at the five light-receiving pixels PGr arranged on the right in the five pixel pairs 90A as described above, the pixel value VGr3 is arranged at a centroid position of these five light-receiving pixels PGr, as illustrated in FIG. 15.

Likewise, the signal processing section 15 subtracts the pixel value VR1 in the image data DT1 from the pixel value VR2 in the image data DT2 to thereby calculate a pixel value VR3. The pixel value VR3 is a value corresponding to the sum of received light amounts at the four light-receiving pixels PR arranged on the right in the four pixel pairs 90A in the pixel block 100R. The pixel value VR3 is arranged at a centroid position of the four light-receiving pixels PR arranged on the right in the four pixel pairs 90A in the pixel block 100R.

The signal processing section 15 subtracts the pixel value VB1 in the image data DT1 from the pixel value VB2 in the image data DT2 to thereby calculate a pixel value VB3. The pixel value VB3 is a value corresponding to the sum of received light amounts at the four light-receiving pixels PB arranged on the right in the four pixel pairs 90A in the pixel block 100B. The pixel value VB3 is arranged at a centroid position of the four light-receiving pixels PB arranged on the right in the four pixel pairs 90A in the pixel block 100B.

The signal processing section 15 subtracts the pixel value VGb1 in the image data DT1 from the pixel value VGb2 in the image data DT2 to thereby calculate a pixel value VGb3. The pixel value VGb3 is a value corresponding to the sum of received light amounts at the five light-receiving pixels PGb arranged on the right in the five pixel pairs 90A in the pixel block 100Gb. The pixel value VGb3 is arranged at a centroid position of the five light-receiving pixels PGb arranged on the right in the five pixel pairs 90A in the pixel block 100Gb.

Then, the image data generator 16 of the signal processing section 15 performs predetermined image processing on the basis of the image data DT2 to thereby generate the image data DP ((A) of FIG. 12) representing the captured image.

In addition, the phase difference data generator 17 of the signal processing section 15 performs predetermined image processing on the basis of the image data DT1 and DT3 to thereby generate the phase difference data DF representing the image-plane phase difference. That is, the image data DT1 includes the pixel values V at the light-receiving pixels P arranged on the left in the plurality of pixel pairs 90A, and the image data DT3 includes the pixel values V at the light-receiving pixels P arranged on the right in the plurality of pixel pairs 90A. The phase difference data generator 17 is therefore able to generate the phase difference data DF on the basis of the image data DT1 and DT3.

In the imaging device 1, as illustrated in FIG. 2, the lenses 101 are provided side by side in the X-axis direction and the Y-axis direction in the pixel array 11. This makes it possible to generate the phase difference data DF at high resolution across the entire surface of the pixel array 11. Therefore, for example, a camera mounted with such an imaging device 1 is able to achieve highly accurate autofocusing and, as a result, is able to increase image quality.

### (Imaging Mode MB)

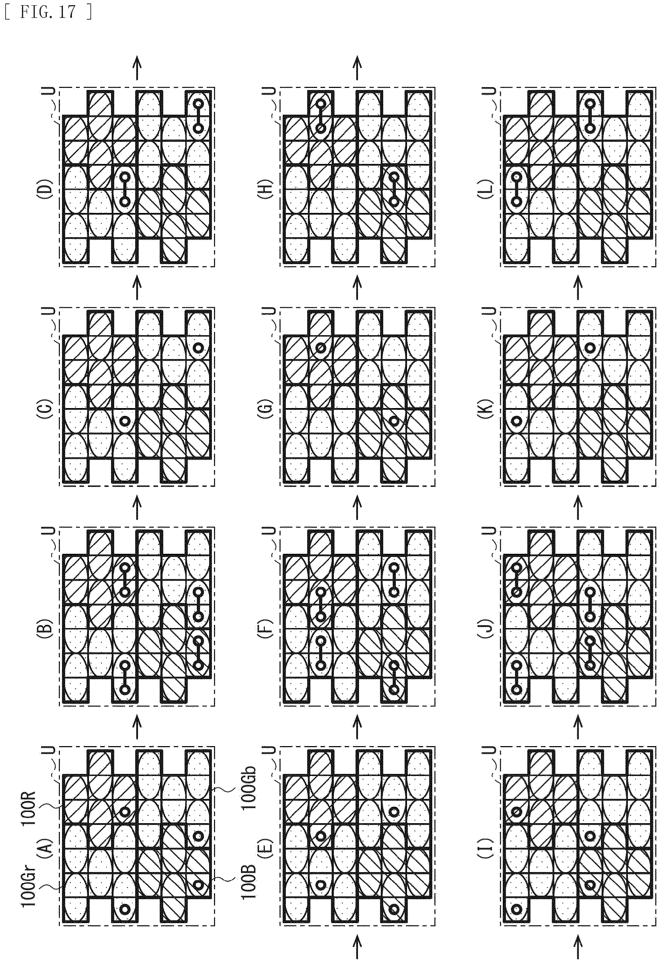

FIG. 16 illustrates an operation example of the imaging device 1 in the imaging mode MB. FIG. 17 more specifically illustrates the operation illustrated in FIG. 16. In FIGs. 16 and 15, the light-receiving pixels P illustrated with "o" represent the light-receiving pixels P that are targeted for the readout operation.

In the pixel block 100Gr, as illustrated in (A) of FIG. 17, the imaging device 1 targets the light-receiving pixel PGr arranged on the left in one pixel pair 90A among the five pixel pairs 90A in the pixel block 100Gr for the readout operation, and calculates the pixel value VGr1 at the position of this light-receiving pixel PGr. Then, as illustrated in (B) of FIG. 17, the imaging device 1 next targets the two light-receiving pixels PGr in the pixel pair 90A for the readout operation, and calculates the pixel value VGr2 at a centroid position of the two light-receiving pixels PGr.

Likewise, in the pixel block 100R, as illustrated in (A) of FIG. 17, the imaging device 1 targets the light-receiving pixel PR arranged on the left in one pixel pair 90A among the four pixel pairs 90A in the pixel block 100R for the readout operation, and calculates the pixel value VR1 at the position of this light-receiving pixel PR. Then, as illustrated in (B) of FIG. 17, the imaging device 1 next targets the two light-receiving pixels PR in the pixel pair 90A for the readout operation, and calculates the pixel value VR2 at a centroid position of the two light-receiving pixels PR.

Likewise, in the pixel block 100B, as illustrated in (A) of FIG. 17, the imaging device 1 targets the light-receiving pixel PB arranged on the left in one pixel pair 90A among the four pixel pairs 90A in the pixel block 100B for the readout operation, and calculates the pixel value VB1 at the position of this light-receiving pixel PB. Then, as illustrated in (B) of FIG. 17, the imaging device 1 next targets the two light-receiving pixels PB in the pixel pair 90A for the readout operation, and calculates the pixel value VB2 at a centroid position of the two light-receiving pixels PB.

Likewise, in the pixel block 100Gb, as illustrated in (A) of FIG. 17, the imaging device 1 targets the light-receiving pixel PGb arranged on the left in one pixel pair 90A among the five pixel pairs 90A in the pixel block 100Gb for the readout operation, and calculates the pixel value VGb 1 at the position of this light-receiving pixel PGb. Then, as illustrated in (B) of FIG. 17, the imaging device 1 next targets the two light-receiving pixels PGb in the pixel pair 90A for the readout operation, and calculates the pixel value VGb2 at a centroid position of the two light-receiving pixels PGb.

The readout operations in (A) and (B) of FIG. 17 are operations similar to the readout operations in the imaging mode MA (FIG. 14) described above. The imaging device 1 thereafter performs operations of (C) and (D) of FIG. 17, operations of (E) and (F) of FIG. 17, operations of (G) and (H) of FIG. 17, operations of (I) and (J) of FIG. 17, and operations of (K) and (L) of FIG. 17. In such a manner, the imaging device 1 generates the image data DT1 ((A) of FIG. 16) including the pixel values VGr1, VR1, VB1, and VGb1 and the image data DT2 ((B) of FIG. 16) including the pixel values VGr2, VR2, VB2, and VGb2.

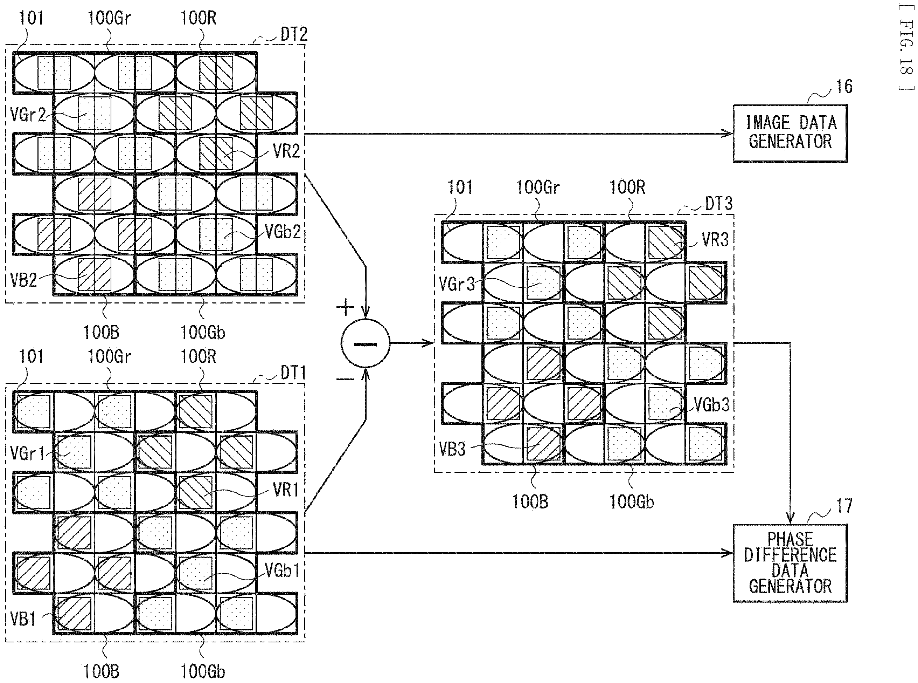

FIG. 18 illustrates an example of image processing by the signal processing section 15 in the imaging mode MB.

First, the signal processing section 15 generates the image data DT3 by performing subtraction processing on the basis of the image data DT1 and DT2.

Specifically, the signal processing section 15 subtracts the five pixel values VGr1 in the image data DT1 respectively from the five pixel values VGr2 in the image data DT2 to thereby calculate five pixel values VGr3. This pixel value VGr3 is a value corresponding to a received light amount at the light-receiving pixel PGr arranged on the right in the pixel pair 90A in the pixel block 100Gr. That is, the pixel value VGr1 is a value corresponding to a received light amount at the light-receiving pixel PGr arranged on the left in the pixel pair 90A in the pixel block 100Gr, and the pixel value VGr2 is a value corresponding to the sum of received light amounts at the two light-receiving pixels PGr in the pixel pair 90A. Therefore, subtracting the pixel value VGr1 from the pixel value VGr2 gives a value corresponding to a received light amount at the light-receiving pixel PGr arranged on the right in the pixel pair 90A in the pixel block 100Gr. As described above, the pixel value VGr3 is the value corresponding to a received light amount at the light-receiving pixel PGr arranged on the right in the pixel pair 90A. Therefore, as illustrated in FIG. 18, the pixel value VGr3 is arranged at the position of the light-receiving pixel PGr arranged on the right in the pixel pair 90A.

Likewise, the signal processing section 15 subtracts the four pixel values VR1 in the image data DT1 respectively from the four pixel values VR2 in the image data DT2 to thereby calculate four pixel values VR3. This pixel value VR3 is a value corresponding to a received light amount at the light-receiving pixel PR arranged on the right in the pixel pair 90A in the pixel block 100R. The pixel value VR3 is arranged at the position of the light-receiving pixel PR arranged on the right in the pixel pair 90A.

The signal processing section 15 subtracts the four pixel values VB1 in the image data DT1 respectively from the four pixel values VB2 in the image data DT2 to thereby calculate four pixel values VB3. This pixel value VB3 is a value corresponding to a received light amount at the light-receiving pixel PB arranged on the right in the pixel pair 90A in the pixel block 100B. The pixel values VB3 are arranged at the positions of the four light-receiving pixels PB arranged on the right in the pixel pairs 90A.

The signal processing section 15 subtracts the five pixel values VGb1 in the image data DT1 respectively from the five pixel values VGb2 in the image data DT2 to thereby calculate five pixel values VGb3. This pixel value VGb3 is a value corresponding to a received light amount at the light-receiving pixel PGb arranged on the right in the pixel pair 90A in the pixel block 100Gb. The pixel value VGb3 is arranged at the position of the light-receiving pixel PGb arranged on the right in the pixel pair 90A.

Then, as illustrated in FIG. 18, the image data generator 16 of the signal processing section 15 performs predetermined image processing on the basis of the image data DT2 to thereby generate the image data DP ((B) of FIG. 12) representing the captured image. The predetermined image processing includes remosaic processing of performing corrections of the pixel values V and performing rearrangement of the pixel values V.

FIG. 19 illustrates an example of the remosaic processing in the imaging mode M2, in which (A) illustrates the image data DT2, (B) illustrates the positions of the pixel values V before and after the remosaic processing, and (C) illustrates image data DT4 generated by the remosaic processing on the basis of the image data DT2. In (B) of FIG. 19, "○" represents the position of the pixel value V in the image data DT2, and "□" represents the position of the pixel value V in the image data DT4.

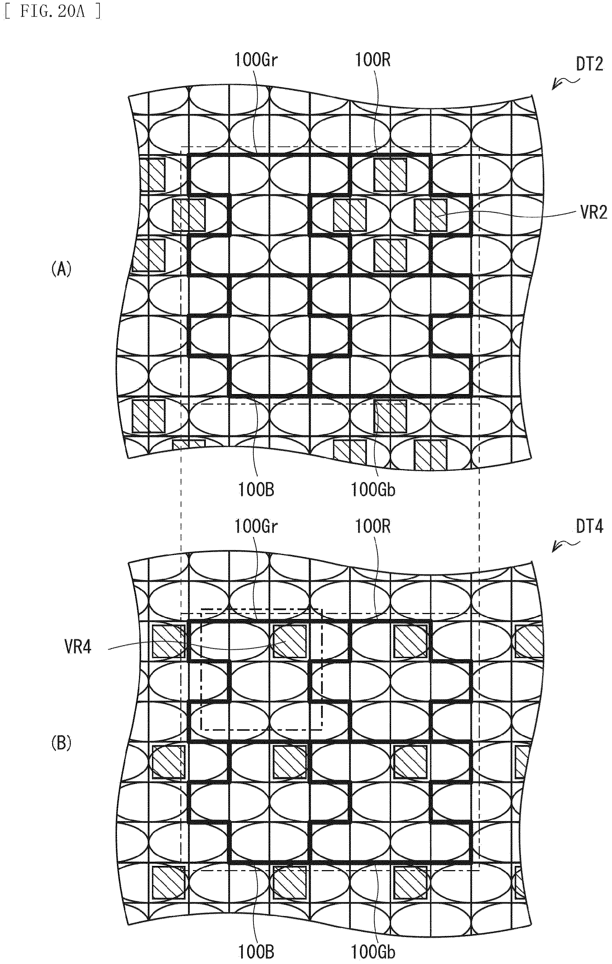

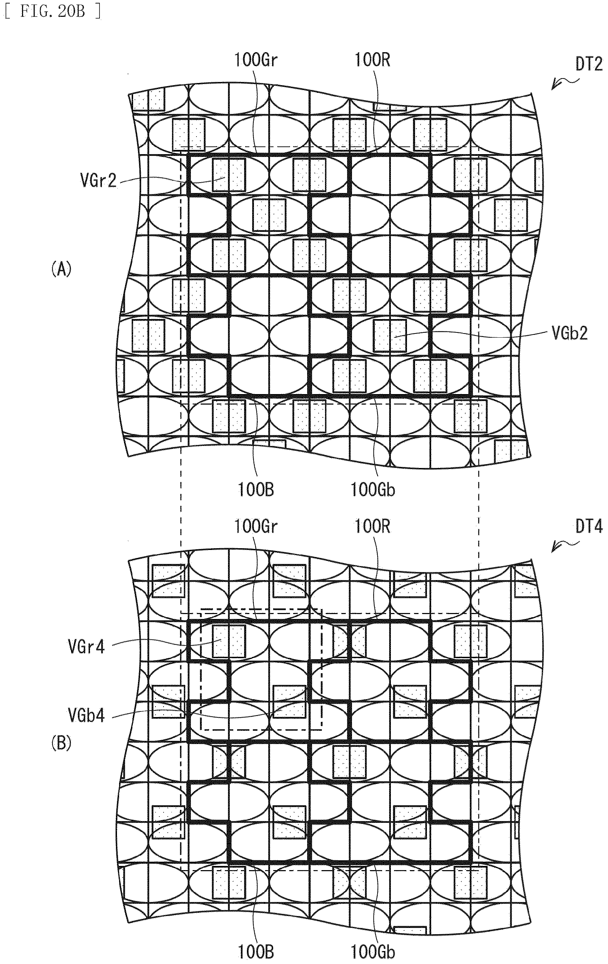

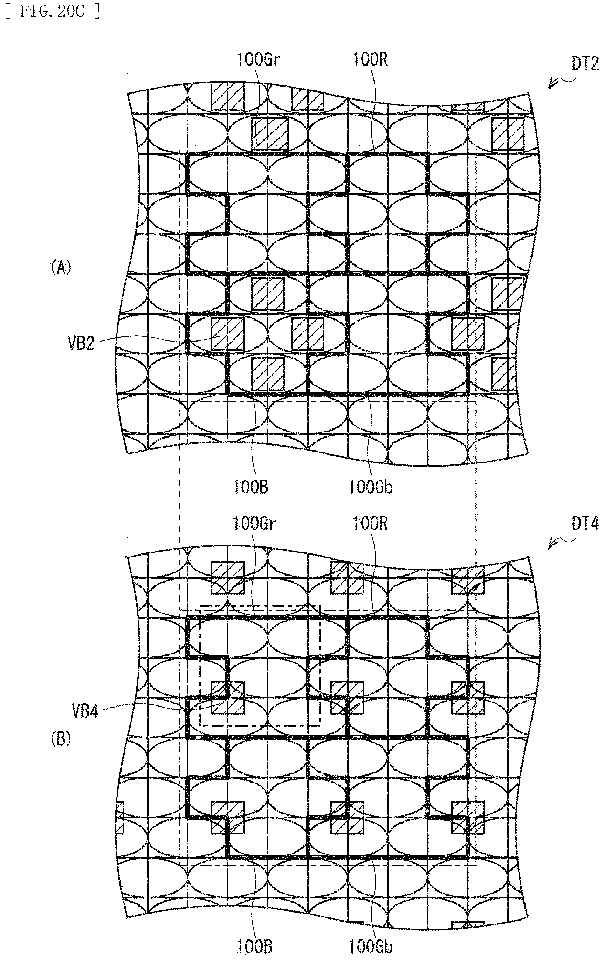

FIG. 20A illustrates the remosaic processing on the pixel block 100R. FIG. 20B illustrates the remosaic processing on the pixel blocks 100Gr and 100Gb. FIG. 20C illustrates the remosaic processing on the pixel block 100B. In FIGs. 20A to 18C, (A) illustrates the image data DT2, and (B) illustrates the image data DT4 generated by the remosaic processing.

As illustrated in (A) of FIG. 19, the image data DT2 includes the pixel values V with a ratio of 18 pixel values V to 36 light-receiving pixels P. For example, in a case where the number of the light-receiving pixels P in the pixel array 11 is 108 [Mpix], the image data DT2 includes the pixel values V for 54 [Mpix]. Meanwhile, as illustrated in (C) of FIG. 19, the image data DT4 includes the pixel values V with a ratio of 16 pixel values V to 36 light-receiving pixels P. For example, in a case where the number of the light-receiving pixels P in the pixel array 11 is 108 [Mpix], the image data DT4 includes the pixel values V for 48 [Mpix]. In addition, in the image data DT4, four pixel values VGr4, VR4, VB4, and VGb4 are arranged in the Bayer arrangement. The image data generator 16 generates such image data DT4 by performing corrections of the pixel values V in the image data DT2 and performing rearrangement of the pixel values V.

Specifically, as illustrated in FIG. 20A, the image data generator 16 performs, for example, complementing processing on the basis of a plurality of pixel values VR2 in the image data DT2 to thereby calculate pixel values V across a surface, and generates the pixel value VR4 on the basis of the pixel values V across the surface. Likewise, as illustrated in FIG. 20B, the image data generator 16 performs, for example, the complementing processing on the basis of a plurality of pixel values VGr2 and VGb2 in the image data DT2 to thereby calculate pixel values V across a surface, and generates the pixel values VGr4 and VGb4 on the basis of the pixel values V across the surface. As illustrated in FIG. 20C, the image data generator 16 performs, for example, the complementing processing on the basis of a plurality of pixel values VB2 in the image data DT2 to thereby calculate pixel values V across a surface, and generates the pixel value VB4 on the basis of the pixel values V across the surface.

In such a manner, the image data generator 16 generates the image data DT4 illustrated in (C) of FIG. 19 on the basis of the image data DT2 illustrated in (A) of FIG. 19. Then, the image data generator 16 performs the predetermined image processing on the basis of the image data DT4 to thereby generate the image data DP ((B) of FIG. 10) representing the captured image.

In addition, as illustrated in FIG. 18, the phase difference data generator 17 of the signal processing section 15 performs the predetermined image processing on the basis of the image data DT1 and DT3 to thereby generate the phase difference data DF representing the image-plane phase difference. That is, the image data DT1 includes the pixel values V at the light-receiving pixels P arranged on the left in the plurality of pixel pairs 90A, and the image data DT3 includes the pixel values V at the light-receiving pixels P arranged on the right in the plurality of pixel pairs 90A. The phase difference data generator 17 is therefore able to generate the phase difference data DF on the basis of the image data DT1 and DT3.

The phase difference data generator 17 generates the phase difference data DF by performing rearrangement of the pixel values V on the basis of the image data DT1 and DT3, in the same manner as the image data generator 16. That is, the image data DT1 and DT3 include the left and right pixel values V for the pixel pairs 90A with a ratio of 18 pixel values V to 36 light-receiving pixels P. The phase difference data generator 17 thus performs rearrangement of the pixel values V to include the left and right pixel values V for the pixel pairs 90A with a ratio of 16 pixel values V to 36 light-receiving pixels P. The phase difference data generator 17 is thereby able to generate the phase difference data DF corresponding to the image data DP generated by the image data generator 16.

### (Imaging Mode MC)

FIG. 19 illustrates an operation example of the imaging device 1 in the imaging mode MC. FIG. 9 more specifically illustrates the operation illustrated in FIG. 19. In FIGs. 19 and 20, the light-receiving pixels P illustrated with "o" represent the light-receiving pixels P that are targeted for the readout operation.

In the pixel block 100Gr, as illustrated in (A) of FIG. 9, the imaging device 1 targets one light-receiving pixel PGr among the ten light-receiving pixels PGr in the pixel block 100Gr for the readout operation, and calculates the pixel value VGr1 at the position of this light-receiving pixel PGr.

FIG. 10 illustrates an example of the readout operation, in which (A) illustrates the waveform of the control signal SSEL, (B) illustrates the waveform of the control signal SRST, (C) illustrates the waveform of the control signal STRG supplied to the light-receiving pixel PGr targeted for the readout operation, (D) illustrates the waveform of the control signal AZ, (E) illustrates the waveform of the reference signal RAMP, (F) illustrates the waveform of the signal SIG, and (G) illustrates the waveform of the signal CP. This readout operation corresponds to the readout operation (FIG. 14) in the imaging modes MA and MB from which the operations during the period from the timing t21 to the timing t26 are omitted. In such a manner, the readout section 20 supplies the image signal SpicO including the count values CNTP and CNTD1 to the signal processing section 15. The signal processing section 15 generates the pixel value VGr1 by utilizing the principle of correlated double sampling on the basis of the count values CNTP and CNTD1 included in the image signal SpicO, for example. Specifically, the signal processing section 15 generates the pixel value VGr1 by, for example, subtracting the count value CNTP from the count value CNTD1.

Likewise, in the pixel block 100R, as illustrated in (A) of FIG. 9, the imaging device 1 targets one light-receiving pixel PR among the eight light-receiving pixels PR in the pixel block 100R for the readout operation, and calculates the pixel value VR1 at the position of this light-receiving pixel PR.

Likewise, in the pixel block 100B, as illustrated in (A) of FIG. 9, the imaging device 1 targets one light-receiving pixel PB among the eight light-receiving pixels PB in the pixel block 100B for the readout operation, and calculates the pixel value VB1 at the position of this light-receiving pixel PB.

Likewise, in the pixel block 100Gb, as illustrated in (A) of FIG. 9, the imaging device 1 targets one light-receiving pixel PGb among the ten light-receiving pixels PGb in the pixel block 100Gb for the readout operation, and calculates the pixel value VGb1 at this light-receiving pixel PGb.

The imaging device 1 thereafter performs the operations of (B) to (L) of FIG. 9. In such a manner, the imaging device 1 generates the image data DT1 (FIG. 19) including the pixel values VGr1, VR1, VB1, and VGb1.

FIG. 11 illustrates an example of image processing by the signal processing section 15 in the imaging mode MC.

The image data generator 16 of the signal processing section 15 performs predetermined image processing on the basis of the image data DT1 to thereby generate the image data DP ((C) of FIG. 10) representing the captured image. The predetermined image processing includes the remosaic processing of performing corrections of the pixel values V and performing rearrangement of the pixel values V.

FIG. 12 illustrates an example of the remosaic processing in the imaging mode MC, in which (A) illustrates the image data DT1, (B) illustrates the positions of the pixel values V before and after the remosaic processing, and (C) illustrates the image data DT4 generated by the remosaic processing on the basis of the image data DT1. In (B) of FIG. 12, "○" represents the position of the pixel value V in the image data DT1, and "□" represents the position of the pixel value V in the image data DT4.

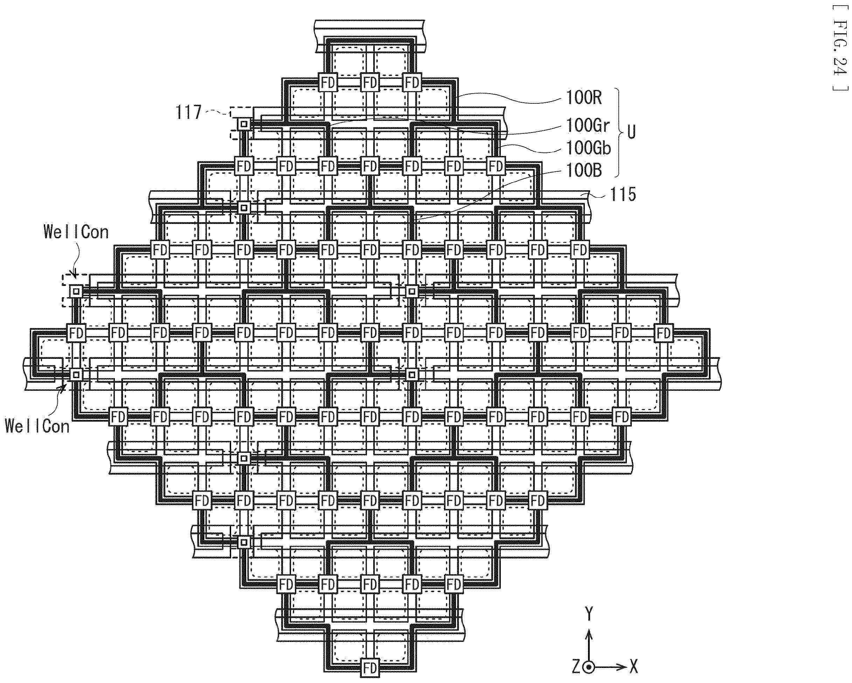

FIG. 13A illustrates the remosaic processing on the pixel block 100R. FIG. 13B illustrates the remosaic processing on the pixel blocks 100Gr and 100Gb. FIG. 13C illustrates the remosaic processing on the pixel block 100B. In FIGs. 13A to 24C, (A) illustrates the image data DT1, and (B) illustrates the image data DT4 generated by the remosaic processing.

In the image data DT4, the four pixel values VGr4, VR4, VB4, and VGb4 are arranged in the Bayer arrangement. The image data generator 16 generates such image data DT4 by performing corrections of the pixel values V in the image data DT1 and performing rearrangement of the pixel values V.

Specifically, as illustrated in FIG. 13A, the image data generator 16 performs, for example, complementing processing on the basis of a plurality of pixel values VR1 in the image data DT1 to thereby calculate pixel values V across a surface, and generates the pixel value VR4 on the basis of the pixel values V across the surface. Likewise, as illustrated in FIG. 13B, the image data generator 16 performs, for example, the complementing processing on the basis of a plurality of pixel values VGr1 and VGb1 in the image data DT1 to thereby calculate pixel values V across a surface, and generates the pixel values VGr4 and VGb4 on the basis of the pixel values V across the surface. As illustrated in FIG. 13C, the image data generator 16 performs, for example, the complementing processing on the basis of a plurality of pixel values VB1 in the image data DT1 to thereby calculate pixel values V across a surface, and generates the pixel value VB4 on the basis of the pixel values V across the surface.

In such a manner, the image data generator 16 generates the image data DT4 illustrated in (C) of FIG. 12 on the basis of the image data DT1 illustrated in (A) of FIG. 12. Then, the image data generator 16 performs the predetermined image processing on the basis of the image data DT4 to thereby generate the image data DP ((C) of FIG. 10) representing the captured image.

In addition, as illustrated in FIG. 11, the phase difference data generator 17 of the signal processing section 15 performs the predetermined image processing on the basis of the image data DT1 to thereby generate the phase difference data DF representing the image-plane phase difference. That is, the image data DT1 includes image data (image data DT11) including the pixel values V at the light-receiving pixels P arranged on the left in the plurality of pixel pairs 90A, and image data (image data DT12) including the pixel values V at the light-receiving pixels P arranged on the right in the plurality of pixel pairs 90A. The phase difference data generator 17 is therefore able to generate the phase difference data DF on the basis of the image data DT1 (image data DT11 and DT12).

As described above, the imaging device 1 is provided with the plurality of pixel blocks 100 that each includes the plurality of light-receiving pixels P including the color filters of mutually the same color. The plurality of light-receiving pixels P is partitioned into the plurality of pixel pairs 90A each including two light-receiving pixels P. Further, the plurality of lenses 101 is provided at the respective positions corresponding to the plurality of pixel pairs 90A. This makes it possible for the imaging device 1 to generate the phase difference data DF at high resolution across the entire surface of the pixel array 11. Therefore, for example, a camera mounted with such an imaging device 1 is able to achieve highly accurate autofocusing with various zoom factors, for example. As a result, the imaging device 1 makes it possible to increase image quality.

In addition, in the imaging device 1, the number of the plurality of light-receiving pixels in a certain pixel block 100 is greater than the number of the plurality of light-receiving pixels in another certain pixel block 100. Specifically, in this example, the number of the light-receiving pixels PGr in the pixel block 100Gr and the number of the light-receiving pixels PGb in the pixel block 100Gb are greater than the number of the light-receiving pixels PR in the pixel block 100R and the number of the light-receiving pixels PB in the pixel block 100B. This makes it possible to, for example, increase the light-receiving sensitivity to green to thereby increase the image quality of a captured image.

In addition, the imaging device 1 is provided with the three imaging modes MA to MC to perform the remosaic processing in the imaging modes MB and MC. Thus, in the imaging device 1, the remosaic processing in the imaging mode MB adjusts the number of effective pixels in the imaging mode MB, in particular, to make it possible to reduce a change in the number of effective pixels in a case where the zoom factor is changed. It is thus possible to suppress a change in the image quality of a captured image.

### [Workings and Effects]

In the imaging device 1 of the present embodiment, the pixel separation section 113 is provided that extends in the X-axis direction and the Y-axis direction between the light-receiving pixels P adjacent to each other to surround each of the plurality of light-receiving pixels P and extends from the back surface 111 S2 of the semiconductor substrate 111 to the front surface 111 S1. On the front surface 111 S1 of the semiconductor substrate 111, the plurality of pixel transistors arranged in the X-axis direction and the element separation section 115 are provided to overlap with the pixel separation section 113 extending in the X-axis direction in a plan view. The element separation section 115 electrically separates the plurality of pixel transistors and the plurality of light-receiving sections 112 provided respectively in the plurality of light-receiving pixels P from each other. The element separation section 115 extends in the X-axis direction along the plurality of pixel transistors arranged in the X-axis direction, and is divided at the intersection of the pixel separation section 113 extending in the X-axis direction and the Y-axis direction, in a plan view. This reduces stress to be applied to the inside of the semiconductor substrate 111. This is described below.

In a CMOS (Complementary Metal Oxide Semiconductor) image sensor to be used for an electronic apparatus such as a digital still camera or a video camera, there is an issue of FD white spot caused by a strong electric field of a source part of a reset transistor in association with pixel miniaturization and with an increase in the number of pixels at an FD. It is possible to solve this issue by using a DTI and an STI instead of an impurity layer to separate the light-receiving section (photodiode; PD) and the pixel transistor from each other and to separate the adjacent pixels from each other.

However, simply replacing the separation between the PD and the pixel transistor by the STI may possibly cause formation of a crystalline defect along the STI, resulting in occurrence of a line defect. This is presumed to be caused by each stress of the DTI and the STI.

In contrast, in the present embodiment, the element separation section 115 electrically separating the plurality of pixel transistors and the plurality of light-receiving sections 112 provided respectively in the plurality of light-receiving pixels P is divided at the intersection of the pixel separation section 113 extending in the X-axis direction and the Y-axis direction, in a plan view. This reduces stress to be applied by the element separation section 115 to the inside of the semiconductor substrate 111.

As described above, in the imaging device 1 according to the present embodiment, the formation of the crystalline defect is reduced, which is caused by each stress of the pixel separation section 113 including the DTI and the element separation section 115 including the STI. It is therefore possible to improve image quality of a captured image.

Next, description is given of a modification example of the present disclosure. Hereinafter, components similar to those of the foregoing embodiment are denoted by the same reference numerals, and descriptions thereof are omitted as appropriate.

### <2. Modification Example>

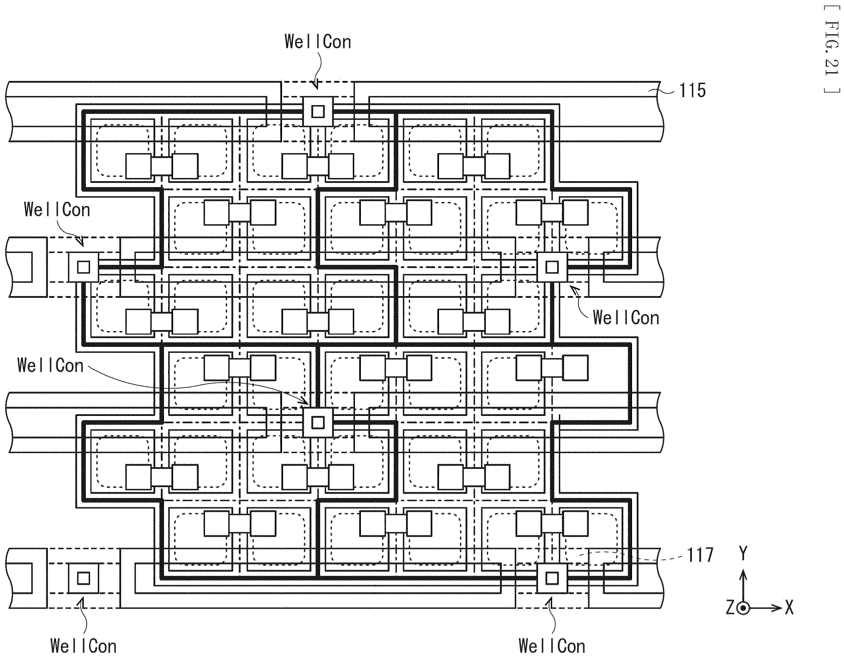

FIG. 21 illustrates another example of a planar configuration in each of the plurality of light-receiving pixels P constituting the pixel blocks 100R, 100Gr, 100Gb, and 100B of the imaging device 1 according to the modification example of the present disclosure.

The foregoing embodiment exemplifies the element separation section 115 being divided for each well contact region WellCon provided at a position overlapping with the intersection of the pixel separation section 113 extending in the X-axis direction and the Y-axis direction in a plan view. However, this is not limitative. For example, as illustrated in FIG. 21, the divided location may be appropriately thinned out together with the well contact region WellCon, e.g., every other well contact region WellCon or every two other well contact region WellCon among a plurality of well contact regions WellCon arranged in the X-axis direction. This makes it possible to increase a channel length and a gate width of the pixel transistor, as compared with the foregoing embodiment.

In addition, the foregoing embodiment exemplifies the case where the pixel blocks 100R and 100B each including eight light-receiving pixels P (light-receiving pixels PR and PB) and the pixel blocks 100Gr and 100Gb each including ten light-receiving pixels P (light-receiving pixel PGr) are arranged, as the unit U, in two rows × two columns. However, this is not limitative.

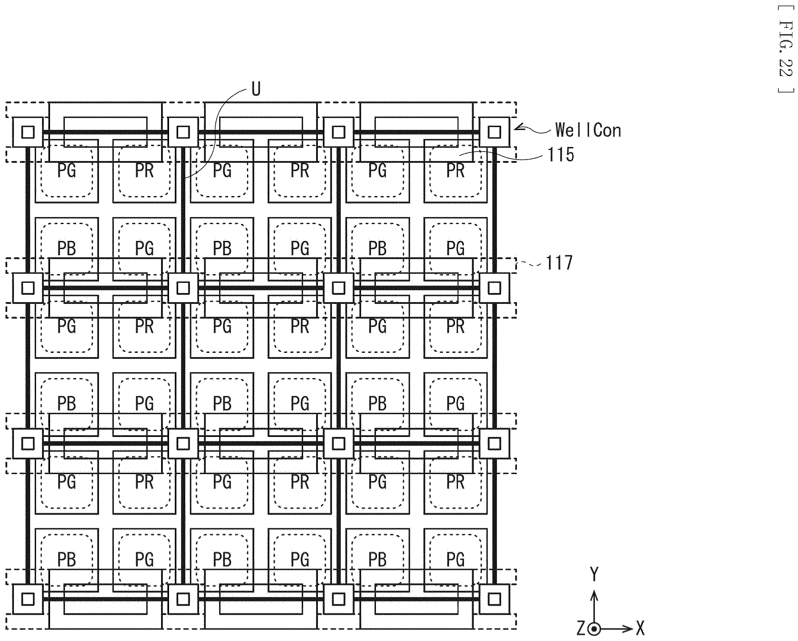

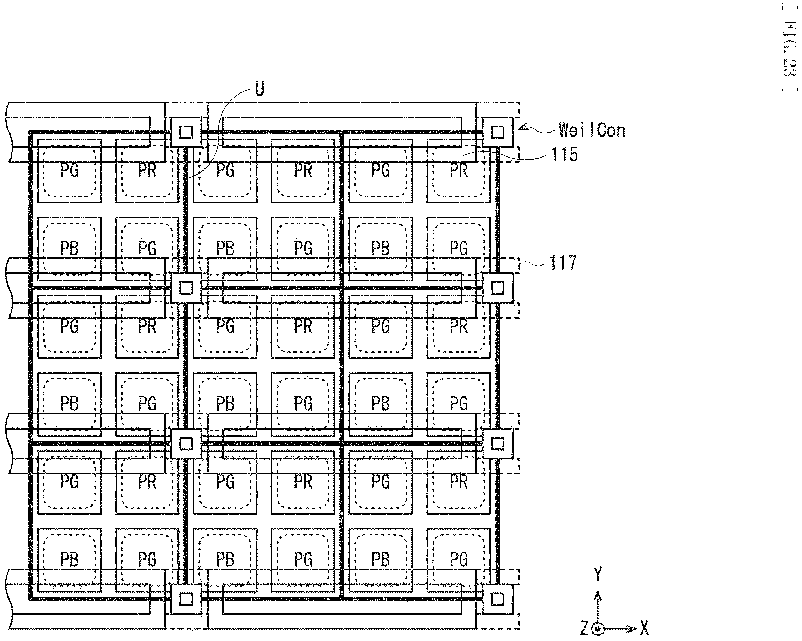

For example, as illustrated in FIG. 22, the present technology is also applicable to an imaging device arranged in two rows × two columns in a Bayer pattern, with a total of four light-receiving pixels of one light-receiving pixel PR and one light-receiving pixel PB and two light-receiving pixels PG being set as the minimum repeating unit (unit U). At that time, as illustrated in FIG. 22, the element separation section 115 may be divided for each unit U; alternatively, for example, as illustrated in FIG. 23, the divided location may be appropriately thinned out.

For example, as illustrated in FIG. 24, the present technology is also applicable to an imaging device in which the pixel block 100R and the pixel block 100Gr are arranged obliquely to each other and the pixel block 100Gb and the pixel block 100B are arranged obliquely to each other, with four pixel blocks 100R, 100Gr, 100Gb, and 100B each including eight light-receiving pixels P being set as the minimum repeating unit (unit U).

### <3. Usage Example of Imaging Device>

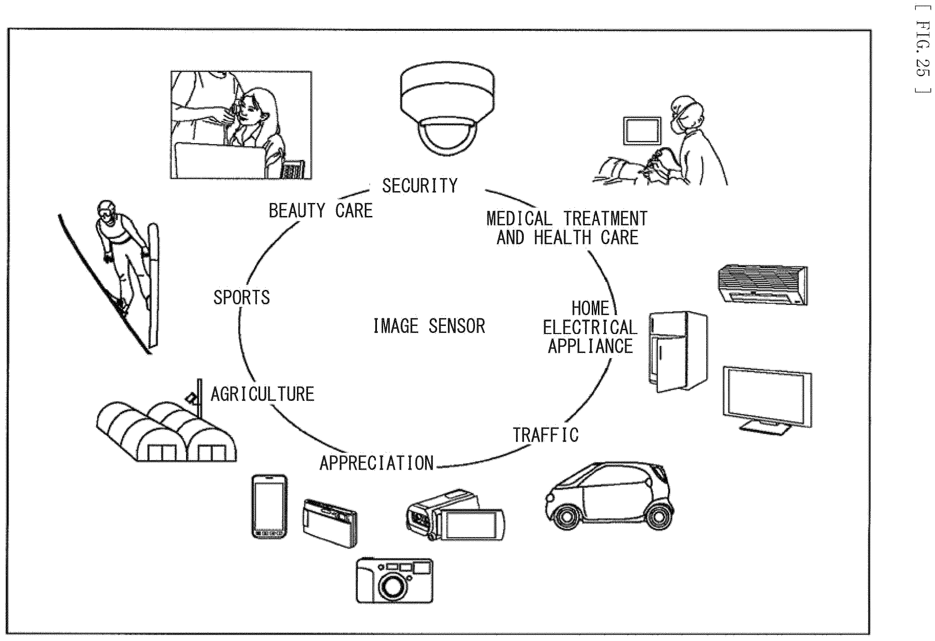

FIG. 25 illustrates a usage example of the imaging device 1 according to the foregoing embodiment. For example, the imaging device 1 described above is usable in a variety of cases of sensing light, including visible light, infrared light, ultraviolet light, and X-rays as follows.
- Apparatuses that shoot images for viewing, including digital cameras and mobile equipment having a camera function

- Apparatuses for traffic use, including onboard sensors that shoot images of the front, back, surroundings, inside, and so on of an automobile for safe driving such as automatic stop and for recognition of a driver's state, monitoring cameras that monitor traveling vehicles and roads, and distance measuring sensors that measure distances including a vehicle-to-vehicle distance
- Apparatuses for use in home electrical appliances including televisions, refrigerators, and air-conditioners to shoot images of a user's gesture and bring the appliances into operation in accordance with the gesture
- Apparatuses for medical treatment and health care use, including endoscopes and apparatuses that shoot images of blood vessels by receiving infrared light
- Apparatuses for security use, including monitoring cameras for crime prevention and cameras for individual authentication
- Apparatuses for beauty care use, including skin measuring apparatuses that shoot images of skin and microscopes that shoot images of scalp
- Apparatuses for sports use, including action cameras and wearable cameras for sports applications and the like
- Apparatuses for agricultural use, including cameras for monitoring the states of fields and crops

### <4. Example of Practical Application to Mobile Body>

The technology (the present technology) according to the present disclosure is applicable to a variety of products. For example, the technology according to the present disclosure may be achieved as an apparatus to be installed aboard any type of mobile body such as an automobile, an electric vehicle, a hybrid electric vehicle, a motorcycle, a bicycle, a personal mobility, an airplane, a drone, a vessel, or a robot.

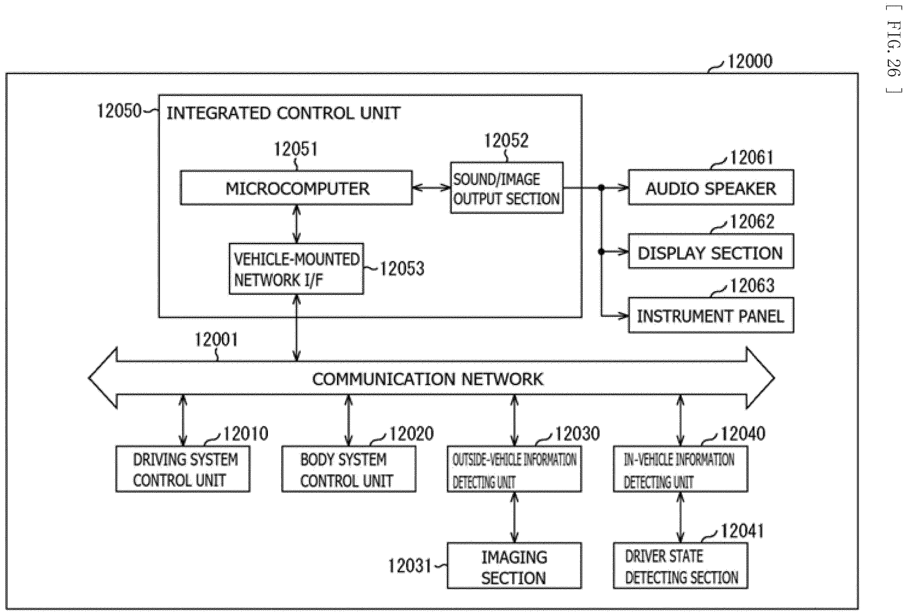

FIG. 26 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 26, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 26, an audio speaker 12061, a display section 12062, and an instrument panel 12063 are illustrated as the output device. The display section 12062 may, for example, include at least one of an on-board display and a head-up display.

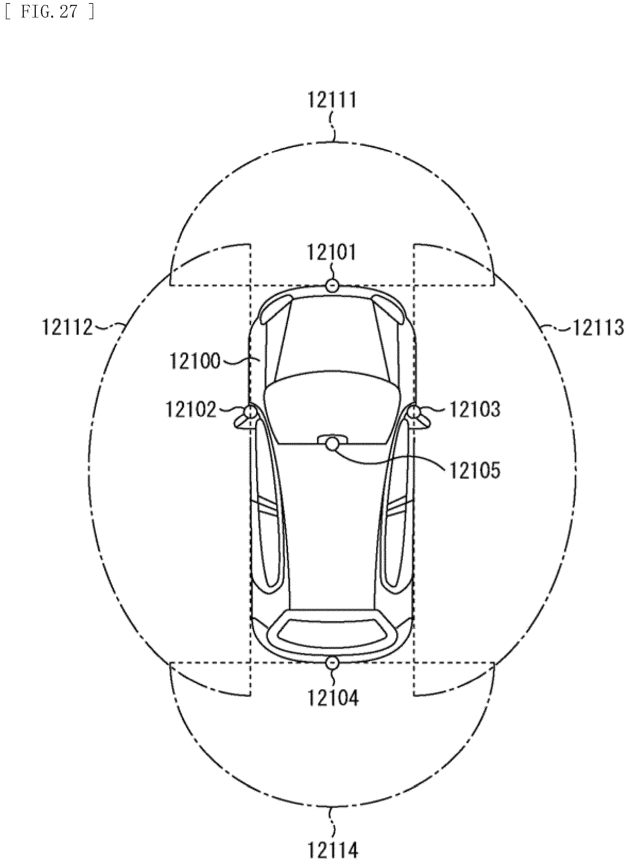

FIG. 27 is a diagram depicting an example of the installation position of the imaging section 12031.

In FIG. 27, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 27 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure is applicable has been described above. The technology according to the present disclosure is applicable to the imaging section 12031 among the above-described components. The imaging device to be installed aboard a vehicle makes it possible to increase the image quality of a captured image. As a result, it is possible for the vehicle control system 12000 to achieve, with high accuracy, a collision avoidance or collision mitigation function for the vehicle, a following driving function based on vehicle-to-vehicle distance, a vehicle speed maintaining driving function, a warning function against collision of the vehicle, a warning function against deviation of the vehicle from a lane, and the like.

Although the present technology has been described above with reference to the embodiment, the modification examples, and the specific practical application example thereof, the present technology is not limited to the embodiment and the like, and may be modified in a wide variety of ways.

For example, the arrangement of the pixel blocks in the pixel array, and the arrangement of the light-receiving pixels P in the pixel blocks are not limited to the arrangements described in the foregoing embodiment and the like, and various arrangements are possible.

It is to be noted that the effects described in the present specification are merely exemplary and non-limiting, and other effects may also be achieved.

It is to be noted that the present technology may have the following configurations. According to the present technology of the following configurations, it is possible to improve image quality of a captured image.
(1) An imaging device including:
   a semiconductor substrate having a first surface and a second surface opposed to each other and including a plurality of light-receiving sections, the plurality of light-receiving sections including a plurality of light-receiving pixels being arranged in a two-dimensional array in a first direction and a second direction intersecting the first direction, the plurality of light-receiving sections generating electric charge corresponding to a received light amount for each of the light-receiving pixels by photoelectric conversion;
   a pixel separation section including an insulating film and extending in the first direction and the second direction between the light-receiving pixels adjacent to each other to surround each of the plurality of light-receiving pixels, the pixel separation section extending from the first surface toward the second surface;
   a plurality of pixel transistors provided on a side of the second surface and arranged in the first direction to overlap with the pixel separation section extending in the first direction in a plan view, the plurality of pixel transistors constituting a readout circuit that outputs a pixel signal based on the electric charge outputted from each of the plurality of light-receiving pixels; and
   an element separation section including an insulating film that is formed to be embedded on the side of the second surface and extending in the first direction along the plurality of pixel transistors arranged in the first direction, the element separation section being divided at at least a portion of an intersection of the pixel separation section that extends in the first direction and the second direction in a plan view, the element separation section electrically separating the plurality of pixel transistors and the plurality of light-receiving sections from each other.
(2) The imaging device according to (1), in which a well contact region that applies fixed electric charge to the semiconductor substrate is formed on the second surface where the element separation section is divided.
(3) The imaging device according to (1) or (2), in which the pixel separation section at and near the intersection protrudes closer to the side of the second surface than the pixel separation section in another region.
(4) The imaging device according to any one of (1) to (3), in which
   the light-receiving pixels are arranged in a two-dimensional array, with a pixel unit including four light-receiving pixels being used as a minimum repeating unit, the four light-receiving pixels being adjacent to each other in the first direction and the second direction, and
   the element separation section is divided at at least a portion of the intersection of the pixel separation section provided at a boundary between a plurality of the pixel units provided side by side in the first direction or the second direction in a plan view.
(5) The imaging device according to any one of (1) to (3), in which
   the plurality of light-receiving pixels is partitioned into a plurality of pixel blocks including the plurality of light-receiving pixels including color filters of same color, and are arranged in a two-dimensional array, with four pixel blocks, among the plurality of pixel blocks, being used as a minimum repeating unit, the four pixel blocks being provided side by side in the first direction and the second direction, and
   the element separation section is divided at at least a portion of the intersection of the pixel separation section provided at a boundary between the plurality of pixel blocks provided side by side in a plan view.
(6) The imaging device according to (5), in which
   the plurality of pixel blocks is partitioned into a plurality of pixel pairs each including two light-receiving pixels adjacent to each other in the first direction, and
   in each of the plurality of pixel blocks, two of the pixel pairs arranged in the second direction are arranged to be shifted in the second direction.
(7) The imaging device according to (5), in which
   the plurality of pixel blocks includes a first pixel block and a second pixel block,
   in the first pixel block, the light-receiving pixels are arranged in a first arrangement pattern, and
   in the second pixel block, the light-receiving pixels are arranged in a second arrangement pattern.
(8) The imaging device according to (7), in which
   the number of the plurality of light-receiving pixels in the first pixel block is greater than the number of the plurality of light-receiving pixels in the second pixel block,
   the plurality of light-receiving pixels included in two of the first pixel blocks includes the color filters of green,
   the plurality of light-receiving pixels included in one of two of the second pixel blocks includes the color filters of red, and
   the plurality of light-receiving pixels included in another of the two of the second pixel blocks includes the color filters of blue.
(9) The imaging device according to any one of (1) to (8), in which the pixel separation section is provided in a grid pattern in a plan view.
(10) The imaging device according to any one of (1) to (9), in which the plurality of pixel transistors includes an amplification transistor, a selection transistor, and a reset transistor.
(11) The imaging device according to (10), further including a conversion efficiency switching transistor as the plurality of pixel transistors.

The present application claims the benefit of Japanese Priority Patent Application JP2021-175964 filed with the Japan Patent Office on October 27, 2021, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. An imaging device comprising:
a semiconductor substrate having a first surface and a second surface opposed to each other and including a plurality of light-receiving sections, the plurality of light-receiving sections including a plurality of light-receiving pixels being arranged in a two-dimensional array in a first direction and a second direction intersecting the first direction, the plurality of light-receiving sections generating electric charge corresponding to a received light amount for each of the light-receiving pixels by photoelectric conversion;
a pixel separation section including an insulating film and extending in the first direction and the second direction between the light-receiving pixels adjacent to each other to surround each of the plurality of light-receiving pixels, the pixel separation section extending from the first surface toward the second surface;
a plurality of pixel transistors provided on a side of the second surface and arranged in the first direction to overlap with the pixel separation section extending in the first direction in a plan view, the plurality of pixel transistors constituting a readout circuit that outputs a pixel signal based on the electric charge outputted from each of the plurality of light-receiving pixels; and
an element separation section including an insulating film that is formed to be embedded on the side of the second surface and extending in the first direction along the plurality of pixel transistors arranged in the first direction, the element separation section being divided at at least a portion of an intersection of the pixel separation section that extends in the first direction and the second direction in a plan view, the element separation section electrically separating the plurality of pixel transistors and the plurality of light-receiving sections from each other.

2. The imaging device according to claim 1, wherein a well contact region that applies fixed electric charge to the semiconductor substrate is formed on the second surface where the element separation section is divided.

3. The imaging device according to claim 1, wherein the pixel separation section at and near the intersection protrudes closer to the side of the second surface than the pixel separation section in another region.

4. The imaging device according to claim 1, wherein
the light-receiving pixels are arranged in a two-dimensional array, with a pixel unit including four light-receiving pixels being used as a minimum repeating unit, the four light-receiving pixels being adjacent to each other in the first direction and the second direction, and
the element separation section is divided at at least a portion of the intersection of the pixel separation section provided at a boundary between a plurality of the pixel units provided side by side in the first direction or the second direction in a plan view.

5. The imaging device according to claim 1, wherein
the plurality of light-receiving pixels is partitioned into a plurality of pixel blocks including the plurality of light-receiving pixels including color filters of same color, and are arranged in a two-dimensional array, with four pixel blocks, among the plurality of pixel blocks, being used as a minimum repeating unit, the four pixel blocks being provided side by side in the first direction and the second direction, and
the element separation section is divided at at least a portion of the intersection of the pixel separation section provided at a boundary between the plurality of pixel blocks provided side by side in a plan view.

6. The imaging device according to claim 5, wherein
the plurality of pixel blocks is partitioned into a plurality of pixel pairs each including two light-receiving pixels adjacent to each other in the first direction, and
in each of the plurality of pixel blocks, two of the pixel pairs arranged in the second direction are arranged to be shifted in the second direction.

7. The imaging device according to claim 5, wherein
the plurality of pixel blocks includes a first pixel block and a second pixel block,
in the first pixel block, the light-receiving pixels are arranged in a first arrangement pattern, and
in the second pixel block, the light-receiving pixels are arranged in a second arrangement pattern.

8. The imaging device according to claim 7, wherein
the number of the plurality of light-receiving pixels in the first pixel block is greater than the number of the plurality of light-receiving pixels in the second pixel block,
the plurality of light-receiving pixels included in two of the first pixel blocks includes the color filters of green,
the plurality of light-receiving pixels included in one of two of the second pixel blocks includes the color filters of red, and
the plurality of light-receiving pixels included in another of the two of the second pixel blocks includes the color filters of blue.

9. The imaging device according to claim 1, wherein the pixel separation section is provided in a grid pattern in a plan view.

10. The imaging device according to claim 1, wherein the plurality of pixel transistors comprises an amplification transistor, a selection transistor, and a reset transistor.

11. The imaging device according to claim 10, further comprising a conversion efficiency switching transistor as the plurality of pixel transistors.
